# EUROPEAN PATENT APPLICATION

(11) **EP 4 580 337 A1**
(43) Date of publication of application: **02.07.2025**
(21) Application number: 24190764.1
(22) Date of filing: 25.07.2024
(51) Int. Cl.: H10D 30/47, H10D 30/01, H10D 64/27, H01L 21/285, H01L 21/3213, H10D 62/17, H10D 64/23, H10D 62/85

(54) **SEMICONDUCTOR DEVICE**

(30) Priority: 28.12.2023 KR 20230194756
(71) Applicant: Samsung Electronics Co., Ltd, Suwon-si, Gyeonggi-do 16677 (KR)
(72) Inventor: PARK, Junhyuk, Suwon-si (KR); KIM, Sanghyun, Suwon-si (KR); KIM, Jongseob, Suwon-si (KR); KIM, Joonyong, Suwon-si (KR); YANG, Seong Seok, Suwon-si (KR); LEE, Jung-Wook, Suwon-si (KR)
(74) Representative: Marks & Clerk LLP

(57) **Abstract**

A semiconductor device includes a channel layer (132), a barrier layer (136) positioned above the channel layer and having a material with a different energy band gap than the channel layer, source (173) and drain (175) electrodes positioned on the channel layer, a gate electrode (155) positioned above the barrier layer between the source and drain electrodes and a gate semiconductor layer (152) positioned between the barrier layer and the gate electrode. The width of the gate electrode is smaller than the width of the gate semiconductor layer at a junction surface of the gate electrode and the gate semiconductor layer.

## Description

### 1. Technical Field

The present disclosure is directed to a semiconductor device.

### 2. Discussion of Related Art

In modern society, a semiconductor device is an electronic component that exploits the electronic properties of a semiconductor material. A semiconductor material has electrical conductivities somewhere between that of a conductor and an insulator, making them useful for a wide range of electronic circuits.

A power semiconductor device is a type of semiconductor device that is designed to handle high voltages and currents without performance degradation. Power semiconductor devices may be used in transportation systems such as electric vehicles, railways, and electric trams; renewable energy systems such as solar power generation and wind power generation; and mobile devices. The power semiconductor device performs functions such as power conversion and control of large-scale power systems or high power electronic devices. The power semiconductor device is able to handle high power and has a high durability. For example, the power semiconductor device may handle voltages of hundreds to thousands of volts and currents of tens of amperes to thousands of amperes. The power semiconductor devices may increase an efficiency of an electrical energy by minimizing power loss. Additionally, the power semiconductor device be operated stably even in environments such as high temperature.

Examples of the power semiconductor device includes a Silicon Carbide (SiC) power semiconductor device and a Gallium Nitride (GaN) power semiconductor device. The SiC power semiconductor devices are resistant to high temperatures and have low power loss, and may be suitable for electric vehicles, renewable energy systems, etc. The GaN power semiconductor devices are expensive to manufacture, but are efficient in terms of speed and may be suitable for high-speed charging of mobile devices.

### SUMMARY

Embodiments of the inventive concept are intended to provide semiconductor devices with stable electric characteristics and increased reliability.

A semiconductor device according to an embodiment includes a channel layer, a barrier layer, source and drain electrodes, a gate electrode, and a gate semiconductor layer. The barrier layer is positioned above the channel layer and includes a material having a different energy band gap than the channel layer. The source and drain electrodes are positioned on the channel layer. The gate electrode is positioned above the barrier layer between the source and drain electrodes. The gate semiconductor layer is positioned between the barrier layer and the gate electrode. A width of the gate electrode is smaller than a width of the gate semiconductor layer at a junction surface of the gate electrode and the gate semiconductor layer.

A semiconductor device according to an embodiment includes a channel layer, a barrier layer, source and drain electrodes and a gate electrode. The channel layer includes GaN. The barrier layer is positioned above the channel layer and includes AlGaN. The source and drain electrodes are positioned on the channel layer. The gate electrode is positioned above the barrier layer between the source and drain electrodes and includes TiN. The atomic percentage of Ti to the atomic percentage of N in an upper part of the gate electrode is lower than the atomic percentage of Ti to the atomic percentage of N in a lower part of the gate electrode.

A semiconductor device according to an embodiment includes a channel layer, a barrier layer, source and drain electrodes, a gate electrode and a gate semiconductor layer. The barrier layer is positioned above the channel layer and has a material having a different energy band gap than the channel layer. The source and drain electrodes are positioned on the channel layer. The gate electrode is positioned above the barrier layer between the source and drain electrodes. The gate semiconductor layer is positioned between the barrier layer and the gate electrode. A width of the lower part of the gate electrode is smaller than a width of the upper part of the gate electrode.

At least some of the above and other features of the disclosure are set out in the claims.

### BRIEF DESCRIPTION OF THE DRAWINGS

FIG. 1 and FIG. 2 are cross-sectional views showing a semiconductor device according to an embodiment.
FIG. 3 is a cross-sectional view showing some layers of a semiconductor device according to an embodiment.
FIG. 4 is a view showing an atomic percentage of materials constituting some layers of a semiconductor device according to an embodiment.
FIG. 5 to FIG. 12 are cross-sectional views showing some layers of a semiconductor device according to an embodiment.
FIG. 13 to FIG. 17 are process cross-sectional views showing a semiconductor device according to an embodiment according to a manufacturing process order.
FIG. 18 is a cross-sectional view showing a semiconductor device according to an embodiment.
FIG. 19 is a cross-sectional view showing a semiconductor device according to an embodiment.
FIG. 20 is a cross-sectional view showing a semiconductor device according to an embodiment.
FIG. 21 to FIG. 27 are process cross-sectional views showing a semiconductor device according to an embodiment according to a manufacturing process order.
FIG. 28 is a cross-sectional view showing a semiconductor device according to an embodiment.
FIG. 29 is a cross-sectional view showing a semiconductor device according to an embodiment.
FIG. 30 is a cross-sectional view showing a semiconductor device according to an embodiment.
FIG. 31 to FIG. 34 are process cross-sectional views showing a semiconductor device according to an embodiment according to a manufacturing process order.
FIG. 35 is a cross-sectional view showing a semiconductor device according to an embodiment.
FIG. 36 is a cross-sectional view showing a semiconductor device according to an embodiment.

### DETAILED DESCRIPTION

The inventive concept will be described more fully hereinafter with reference to the accompanying drawings, in which embodiments thereof are shown. However, the described embodiments may be modified in various different ways, all without departing from the scope of the present invention.

Like reference numerals designate like elements throughout the specification.

Further, while various sizes and thicknesses of constituent members shown in the accompanying drawings, the inventive concept is not limited to the illustrated sizes and thicknesses.

It will be understood that when an element such as a layer, film, region, or substrate is referred to as being "on" another element, it can be directly on the other element or intervening elements may also be present.

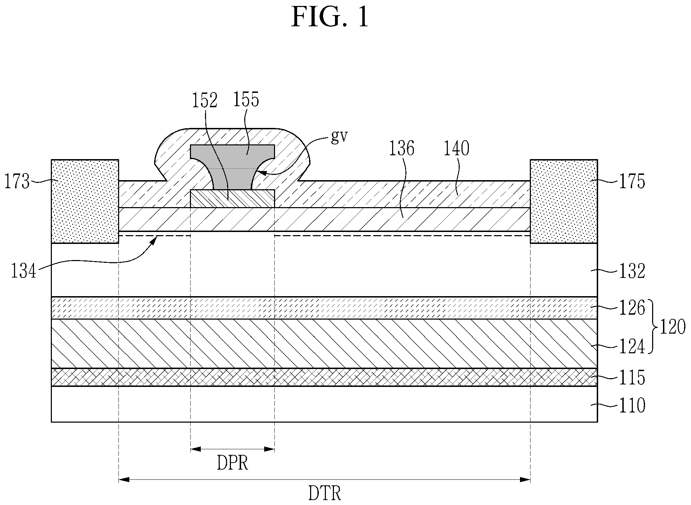

Hereinafter, a semiconductor device according to an embodiment is described with reference to FIG. 1 to FIG. 4.

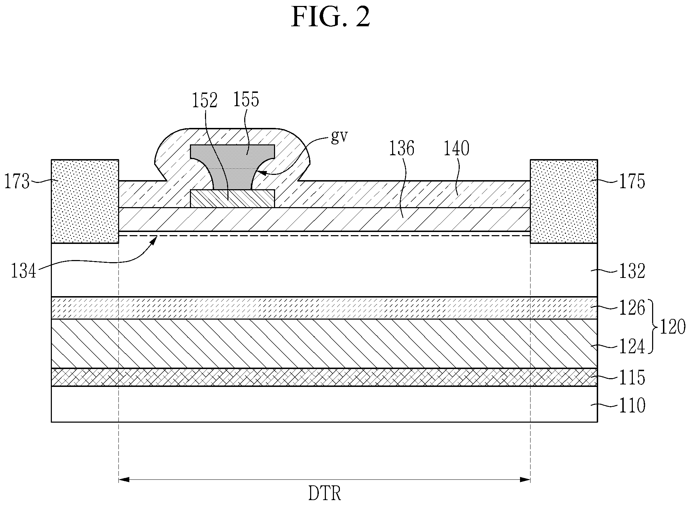

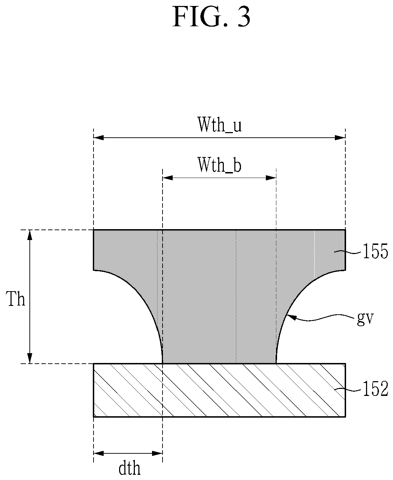

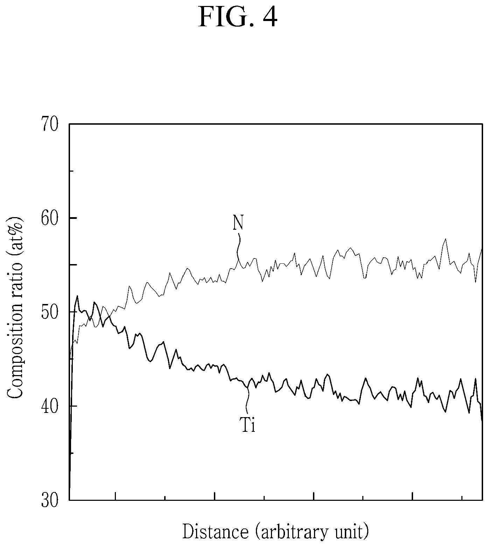

FIG. 1 and FIG. 2 are cross-sectional views showing a semiconductor device according to an embodiment. FIG. 1 represents a case where the semiconductor device according to an embodiment is in an off state. FIG. 2 represents a case where the semiconductor device according to an embodiment is in an on state. For example, the semiconductor device may not be receiving sufficient power to operate during the off state and may be receiving sufficient power to operate during the on state. FIG. 3 is a cross-sectional view showing some layers of a semiconductor device according to an embodiment. FIG. 3 shows a gate semiconductor layer and a gate electrode of the semiconductor device according to an embodiment, and the remaining components are omitted. FIG. 4 is a view showing an atomic percentage of materials constituting some layers of a semiconductor device according to an embodiment. For example, in an embodiment, the atomic percentage of the materials constituting the gate electrode of the semiconductor device.

As shown in FIG. 1, a semiconductor device according to an embodiment includes a channel layer 132, a barrier layer 136 positioned on the channel layer 132 (e.g., above in the Z-axis direction), a gate electrode 155 positioned on the barrier layer 136 (e.g., above in the Z-axis direction), a gate semiconductor layer 152 positioned between the barrier layer 136 and the gate electrode 155, and a source electrode 173 and a drain electrode 175 spaced apart from each other (e.g., in the Y-axis or X-axis direction) on the channel layer 132.

The channel layer 132 is a layer that forms a channel between the source electrode 173 and the drain electrode 175. A 2-dimensional electron gas (2DEG) 134 may be positioned inside the channel layer 132. The 2-dimensional electron gas 134 is a charge transport model used in solid-state physics, and refers to a group of electrons that can move freely in 2-dimensions (e.g., a x-y planar direction) but cannot move in another dimension (e.g., a z direction) and are tightly bound within a 2-dimensional space. In other words, the 2-dimensional electron gas 134 may exist in a 2-dimensional paper-like form within a 3-dimensional space. This 2-dimensional electron gas 134 mainly appears in a semiconductor heterojunction structure, and may occur at the interface between the channel layer 132 and the barrier layer 136 in the semiconductor device according to an embodiment. For example, the 2-dimensional electron gas 134 may be generated in the portion closest to the barrier layer 136 within the channel layer 132.

The channel layer 132 may include one or more materials selected from Group III-V materials, for example, nitrides at least one among Al, Ga, In, and B. The channel layer 132 may be a single layer or multiple layers. The channel layer 132 may be AlₓIn_{y}Ga_{(1-x-y)}N (0≤x≤1, 0≤y≤1, x+y≤1). For example, the channel layer 132 may include at least one of AIN, GaN, InN, InGaN, AlGaN, AllnN, and AllnGaN. The channel layer 132 may be a layer with a doped impurity or a layer with a undoped impurity. The thickness of the channel layer 132 may be about several hundred nanometer (nm) or less.

The channel layer 132 may be positioned on the substrate 110, and a seed layer 115 and a buffer layer 120 may be positioned between the substrate 110 and the channel layer 132. The substrate 110, the seed layer 115, and the buffer layer 120 are layers to support the channel layer 132, and one or more of them may be omitted in some cases. For example, when a substrate made of GaN is used as the channel layer 132, at least one of the substrate 110, the seed layer 115, the buffer layer 120 may be omitted. Since the manufacturing cost of a substrate made of GaN is relatively high, the channel layer 132 may be grown using the substrate 110 made of Si. Since a lattice structure of Si and a lattice structure of GaN are different, it may not be easy to grow the channel layer 132 directly on the substrate 110. Accordingly, the seed layer 115 and the buffer layer 120 may be grown on the substrate 110 first, and then the channel layer 132 may be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, aluminum nitride (AIN), GaN, or a combination thereof. The substrate 110 may be a silicon on insulator (SOI) substrate. However, the material of the substrate 110 is not limited to this, and any generally-used substrate may be applied. In some cases, the substrate 110 may include an insulating material. For example, after forming several layers, including the channel layer 132, on the semiconductor substrate, then the semiconductor substrate may be removed to be replaced with an insulation substrate.

The seed layer 115 may be positioned on the substrate 110. The seed layer 115 may be positioned directly on the substrate 110. However, it is not limited to this, and another predetermined layer may be further positioned between the substrate 110 and the seed layer 115. The seed layer 115 is a layer that serves as a seed for growing the buffer layer 120, and may be made of a crystal lattice structure that becomes the seed of the buffer layer 120. For example, the seed layer 115 may include AIN, but it is not limited thereto.

The buffer layer 120 may be positioned above the seed layer 115. For example, the buffer layer 120 may be positioned directly on the seed layer 115. However, it is not limited to this, and another predetermined layer may be positioned between the seed layer 115 and the buffer layer 120. The buffer layer 120 may be positioned between the seed layer 115 and the channel layer 132. The buffer layer 120 may include one or more materials selected from Group III-V materials, such as nitrides including at least one among Al, Ga, In, B. The buffer layer 120 may be AlₓIn_{y}Ga_{(1-x-y)}N (0≤x≤1, 0≤y≤1, x+y≤1). For example, the buffer layer 120 may include at least one of AIN, GaN, InN, InGaN, AlGaN, AllnN, and AllnGaN. The buffer layer 120 may be a single layer or multiple layers. The buffer layer 120 may include a superlattice layer 124 and a high-resistance layer 126 positioned on (e.g., in the Z-axis direction) the superlattice layer 124. The high-resistance layer 126 may be positioned above the superlattice layer 124. At least one of the superlattice layer 124 and the high-resistance layer 126 may be omitted. In some cases, the buffer layer 120 may include not only the superlattice layer 124 and the high-resistance layer 126, but also other additional layers.

The superlattice layer 124 may be positioned above the seed layer 115. The superlattice layer 124 may be positioned directly on the seed layer 115. However, it is not limited to this, and another predetermined layer may be positioned between the seed layer 115 and the superlattice layer 124. The superlattice layer 124 may be positioned between the substrate 110 and the channel layer 132. The superlattice layer 124 may alleviate the difference in lattice constants and thermal expansion coefficients between the substrate 110 and the channel layer 132, thereby reducing a tensile stress and a compressive stress generated between the substrate 110 and the channel layer 132. The superlattice layer 124 may relieve a compressive stress and relieve a stress between entire layers formed by a growth in the final structure of the semiconductor device according to an embodiment. The superlattice layer 124 may include one or more materials selected from Group III-V materials, such as nitrides including at least one among Al, Ga, In, B. The superlattice layer 124 may be AlₓIn_{y}Ga_{(1-x-y)}N (0≤x≤1, 0≤y≤1, x+y≤1). For example, the superlattice layer 124 may include at least one among AIN, GaN, InN, InGaN, AlGaN, AllnN, AllnGaN. The superlattice layer 124 may be a single layer or multiple layers. For example, the superlattice layer 124 may have a structure in which a layer made of AlGaN and a layer made of GaN are repeatedly stacked. For example, AIGaN/GaN/AIGaN/GaN/AIGaN/GaN may be sequentially stacked on the seed layer 115 to form the superlattice layer 124. However, the number of AlGaN layers and GaN that make up the superlattice layer 124 may be changed in various ways, and the material that makes up the superlattice layer 124 may be changed in various ways.

The high-resistance layer 126 may be positioned above (e.g., in the Z-axis direction) the superlattice layer 124. For example, the high-resistance layer 126 may be positioned directly on the superlattice layer 124. However, it is not limited to this, and other predetermined layers may be positioned between the superlattice layer 124 and the high-resistance layer 126. The high-resistance layer 126 may be positioned between the superlattice layer 124 and the channel layer 132. The high-resistance layer 126 is used to prevent the semiconductor device according to an embodiment from being degraded by preventing a parasitic current (a leakage current) from flowing through the channel layer 132. The high-resistance layer 126 may be made of a material with low conductivity so that the substrate 110 and the channel layer 132 are electrically insulated. For example, the material may be an insulator. The high-resistance layer 126 may include one or more materials selected from Group III-V materials, such as nitrides including at least one among Al, Ga, In, B. The high-resistance layer 126 may be AlₓIn_{y}Ga_{(1-x-y)}N (0≤x≤1, 0≤y≤1, x+y≤1). For example, the high-resistance layer 126 may include at least one of AIN, GaN, InN, InGaN, AlGaN, AllnN, and AllnGaN. The high-resistance layer 126 may be a single layer or multiple layers. The high-resistance layer 126 may be a layer in which impurity is not doped. However, it is not limited to this, and the high-resistance layer 126 may include an impurity. For example, the high-resistance layer 126 may be doped with an impurity made of carbon (C), magnesium (Mg), iron (Fe), or a combination thereof. In an embodiment, the impurity doping concentration of the high-resistance layer 126 is different from the impurity doping concentration of the channel layer 132.

The barrier layer 136 may be positioned above the channel layer 132 (e.g., in the Z-axis direction). The barrier layer 136 may be positioned directly on the channel layer 132. However, it is not limited to this, and another predetermined layer may be further positioned between the channel layer 132 and the barrier layer 136. The region of the channel layer 132 that overlaps the barrier layer 136 may be referred to as a drift region DTR. In other words, the barrier layer 136 may only overlay a portion of the channel layer 132. The barrier layer 136 may only overlay the drift region DTR of the channel layer 132. The drift region DTR may be positioned between the source electrode 173 and the drain electrode 175. When a potential difference occurs between the source electrode 173 and the drain electrode 175, carriers may move into the drift region DTR. The semiconductor device according to an embodiment may be turned on/off depending on whether a voltage is applied to the gate electrode 155 and/or the size of the voltage applied to the gate electrode 155. When a voltage higher than a threshold voltage is applied to the gate electrode 155 to turn on the semiconductor device, a channel may be created in a depletion region DPR. Accordingly, the movement of the carrier may occur in the drift region DTR. If a voltage lower than the threshold voltage is applied to the gate electrode 155 or no voltage is applied, the channel path may be blocked in the depletion region DPR and the movement of the carrier may not occur.

The barrier layer 136 may include one or more materials selected from Group III-V materials, such as nitrides including at least one among Al, Ga, In, B. The barrier layer 136 may be AlₓIn_{y}Ga_{(1-x-y)}N (0≤x≤1, 0≤y≤1, x+y≤1). The barrier layer 136 may include at least one of GaN, InN, AlGaN, AllnN, InGaN, AIN, AllnGaN, etc. The energy band gap of the barrier layer 136 may be adjusted by the composition ratio of Al and/or In.

In an embodiment, the barrier layer 136 includes or is a semiconductor material with characteristics different from those of the channel layer 132. For example, the material of the barrier layer 136 may differ from the material of the channel layer 132. The barrier layer 136 may differ from the channel layer 132 in at least one of a polarization characteristic, an energy band gap, and a lattice constant. For example, the barrier layer 136 may include a material having an energy band gap different from the energy band gap of the channel layer 132. In an embodiment, the barrier layer 136 has a higher energy band gap than the channel layer 132 and may have a higher electrical polarization rate than the channel layer 132. Due to the barrier layer 136, a two-dimensional electron gas 134 may be induced in the channel layer 132, which has a relatively low electrical polarization rate. In this regard, the barrier layer 136 may also be referred to as a channel supply layer or a two-dimensional electron gas supply layer. The two-dimensional electron gas 134 may be formed within a portion of the channel layer 132 positioned below the interface between the channel layer 132 and the barrier layer 136. The two-dimensional electron gas 134 may have very high electron mobility.

The barrier layer 136 may be a single layer or multiple layers. If the barrier layer 136 is made of multiple layers, the energy band gap of the material of each layer constituting the multiple layers may be different. In an embodiment, the multiple layers constituting the barrier layer 136 are arranged so that the energy band gap increases as it approaches the channel layer 132. For example, the energy band gap of a lower layer of the barrier layer 135 may be higher than an energy band gap of a higher layer of the barrier layer 135 that is further away from the channel layer 132.

The gate electrode 155 may be positioned on (e.g., in the Z-axis direction) the barrier layer 136. The gate electrode 155 may overlap with some regions of the barrier layer 136. The gate electrode 155 may overlap with a part of the drift region DTR of the channel layer 132. The gate electrode 155 may be positioned between the source electrode 173 and the drain electrode 175. The gate electrode 155 may be separated from the source electrode 173 and the drain electrode 175. In an embodiment, the gate electrode 155 is positioned closer to the source electrode 173 than the drain electrode 175. That is, the separation distance between the gate electrode 155 and the source electrode 173 may be smaller than the separation distance between the gate electrode 155 and the drain electrode 175. In an embodiment, the gate electrode 155 is in contact with the gate semiconductor layer 152. A bottom surface of the gate electrode 155 may be in contact with the gate semiconductor layer 152. However, it is not limited to this, and another predetermined layer may be positioned between the gate electrode 155 and the gate semiconductor layer 152.

The gate electrode 155 may include a conductive material. For example, the gate electrode 155 may include a metal, a metal alloy, a conductive metal nitride, a metal silicide, a doped semiconductor material, a conductive metal oxide, or a conductive metal oxynitride. For example, the gate electrode 155 may be a conductor. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonizationnitride (TiAIC-N), titanium aluminum carbide (TiAIC), titanium carbide (TiC), tantalum carbonizationnitride (TaCN), tungsten(W), aluminum (Al), copper(Cu), cobalt(Co), titanium (Ti), tantalum (Ta), nickel(Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (lr), osmium (Os), silver (Ag), gold (Au), zinc(Zn), vanadium (V), or combination thereof, but it is not limited thereto. The gate electrode 155 may be a single layer or multiple layers.

The gate semiconductor layer 152 may be positioned between the barrier layer 136 and the gate electrode 155. That is, the gate semiconductor layer 152 may be positioned on the barrier layer 136, and the gate electrode 155 may be positioned on the gate semiconductor layer 152 (e.g., in the Z axis or vertical direction). The gate electrode 155 may be in Schottky contact with the gate semiconductor layer 152. However, it is not limited to this, and in some cases, the gate electrode 155 may be in ohmic contact with the gate semiconductor layer 152. The gate semiconductor layer 152 may overlap with the gate electrode 155 in a vertical direction (or vice versa depending on perspective). The vertical direction may mean a direction vertical to the upper surface of the channel layer 136 or the barrier layer 136.

The gate semiconductor layer 152 may be positioned between (e.g., in the X or Y axis or horizontal direction) the source electrode 173 and the drain electrode 175. The gate semiconductor layer 152 may be separated from the source electrode 173 and the drain electrode 175. That is, there may be separation distance (e.g., in the X or Y axis or horizontal direction) between the gate semiconductor layer 152 and the source electrode 173 and a separation distance (e.g., in the X or Y axis or horizontal direction) between the gate semiconductor layer 152 and the drain electrode 175. The gate semiconductor layer 152 may be positioned closer to the source electrode 173 than the drain electrode 175. That is, the separation distance between the gate semiconductor layer 152 and the source electrode 173 may be smaller than the separation distance between the gate semiconductor layer 152 and the drain electrode 175.

The gate semiconductor layer 152 may include one or more materials selected from Group III-V materials, such as nitrides including at least one among Al, Ga, In, B. The gate semiconductor layer 152 may be AlₓIn_{y}Ga_{(1-x-y)}N (0≤x≤1, 0≤y≤1, x+y≤1). For example, the gate semiconductor layer 152 may include at least one of AIN, GaN, InN, InGaN, AlGaN, AlInN, AlInGaN. In an embodiment, the gate semiconductor layer 152 includes or is a material having a different energy band gap than the barrier layer 136. For example, the gate semiconductor layer 152 may include GaN, and the barrier layer 136 may include AlGaN. For example, in an embodiment, the barrier layer 136 includes AlGaN; and the gate semiconductor layer 152 includes GaN, but no Al. The gate semiconductor layer 152 may be doped to a predetermined impurity. In an embodiment, the impurity doped in the gate semiconductor layer 152 is a P-type dopant that can provide a hole. For example, the gate semiconductor layer 152 may include GaN doped with a P-type impurity. That is, the gate semiconductor layer 152 may be made of a p-GaN layer. However, it is not limited to this, and the gate semiconductor layer 152 may be a p-AlGaN layer. For example, the impurity doped in the gate semiconductor layer 152 may be magnesium (Mg). The gate semiconductor layer 152 may be a single layer or multiple layers.

Below, the shape of the gate semiconductor layer 152 and the gate electrode 155 and the atomic percentage of the materials are described further with reference to FIG. 3 and FIG. 4.

Referring further to FIG. 3, the gate electrode 155 includes a groove gv that is recessed from the bottom surface and side surface of the gate electrode 155. At least a portion of the gate electrode 155 may be separated from the gate semiconductor layer 152 by the groove gv. In other words, the groove gv may separate the portion of the gate electrode 155 such that the portion is a space between the portion and the gate semiconductor layer. The groove gv of the gate electrode 155 may include a curved surface. The groove gv may have a convex curved surface shape. Within the groove gv, the slope of the side surface of the gate electrode 155 with respect to the gate semiconductor layer 152 may gradually increase as it approaches the gate semiconductor layer 152. For example, the slope of the side surface of the gate electrode 155 within the groove gv may range from about 0 degrees to about 90 degrees. In the area close to the gate semiconductor layer 152, the slope of the side surface of the gate electrode 155 may be close to about 90 degrees. However, it is not limited thereto. For example, the shape of the groove gv may be changed in various ways. The width of the gate electrode 155 may gradually increase from the lower part to the upper part and then become constant. In an embodiment, the width Wth_b of the lower part of the gate electrode 155 is smaller than the width Wth_u of the upper part of the gate electrode 155. The width Wth_b of the lower part of the gate electrode 155 may be a minimum width of the gate electrode 155, and the width Wth_u of the upper part of the gate electrode 155 may be a maximum width of the gate electrode 155. The width of the gate semiconductor layer 152 may be almost constant. In an embodiment, the width of the lower part of the gate semiconductor layer 152 is the same as the width of the upper part of the gate semiconductor layer 152. The width Wth_b of the lower part of the gate electrode 155 may be smaller than the width of the gate semiconductor layer 152. In an embodiment, at the contact area between the gate electrode 155 and the gate semiconductor layer 152, the width of the gate electrode 155 is smaller than the width of the gate semiconductor layer 152. The contact area or surface may form a junction area or surface between the gate electrode 155 and gate semiconductor layer 152. Generally, the gate electrode 155 may have a top surface, one or more side surfaces, and a bottom surface generally opposite the top surface. The bottom surface may form the junction surface which contacts the gate semiconductor layer 152. The junction surface may be defined as a portion of a surface of the gate electrode 155 which is in contact with a surface of the gate semiconductor layer 152. The junction surface may be a portion of the gate electrode 155 which contacts the gate semiconductor layer 152. Accordingly, at least a portion of the upper surface of the gate semiconductor layer 152 may not be covered by the gate electrode 155. Both edges of the upper surface of the gate semiconductor layer 152 may not be covered by the gate electrode 155. In an embodiment, the left edge of the gate semiconductor layer 152 and the right edge of the gate semiconductor layer 152 that opposes the left edge are not covered by the gate electrode 155. In an embodiment, the width Wth_u of the upper part of the gate electrode 155 is the same or substantially the same as the width of the gate semiconductor layer 152. The gate semiconductor layer 152 may have substantially the same planar shape as the upper part of the gate electrode 155.

In an embodiment, the depth dth of the groove gv of the gate electrode 155 corresponds to the difference between the width Wth_u of the upper part and the width Wth_b of the lower part of the gate electrode 155. The depth dth of the groove gv of the gate electrode 155 may exceed 0 and be about 1 µm or less. In an embodiment, the depth dth of the groove gv of the gate electrode 155 is about 5 nm or more and about 300 nm or less. The difference between the width Wth_u of the upper part of the gate electrode 155 and the width Wth_b of the lower part of the gate electrode 155 may be greater than 0 and less than or equal to about 1 µm, and in an embodiment is greater than or equal to about 5 nm and less than or equal to about 300 nm. The thickness Th (e.g., in a Z axis or vertical direction) of the gate electrode 155 may be about 200Å or more and about 3000Å or less. In an embodiment, the thickness Th of the gate electrode 155 is about 500Å or more and about 1500Å or less.

Referring further to FIG. 4, the gate electrode 155 may include TiN. In an embodiment, the gate electrode 155 only includes TiN. In FIG. 4, the horizontal axis means the distance from the bottom surface of the gate electrode 155 (i.e., the junction surface), and the vertical axis means the atomic percentage of the materials included within the gate electrode 155. The unit of the horizontal axis is omitted and may be determined according to the thickness of the gate electrode 155. The left end of the horizontal axis may refer to the bottom surface of the gate electrode 155, and the right end of the horizontal axis may refer to the upper surface of the gate electrode 155.

In an embodiment, the gate electrode 155 is made of a material including Ti and N. In an embodiment, the atomic percentage of Ti in the gate electrode 155 decreases based on a total number of atoms in the gate electrode 155 as the distance from the bottom surface (i.e., the junction surface) of the gate electrode 155 increases. The atomic percentage of Ti in the gate electrode 155 may tend to decrease based on a total number of atoms in the gate electrode 155 as it (e.g., the gate electrode 155) moves away from the gate semiconductor layer 152. The atomic percentage of Ti in the gate electrode 155 may decrease or remain constant based on a total number of atoms in the gate electrode 155 as a distance from the gate semiconductor layer increases. The atomic percentage of Ti in the gate electrode 155 may tend to decrease from the lower part to the upper part based on a total number of atoms in the gate electrode 155. The atomic percentage of Ti may be constant in at least a partial region of gate electrode 155. For example, the atomic percentage of Ti in the gate electrode 155 may gradually decrease as the distance from the gate semiconductor layer 152 increases and then be almost constant. The atomic percentage of N in the gate electrode 155 may tend to increase as the distance from the gate semiconductor layer 152 increases. The atomic percentage of N in the gate electrode 155 may tend to increase from the lower part toward the upper part. The atomic percentage of N in the gate electrode 155 may be constant based on a total number of atoms in the gate electrode in at least partial region of the gate electrode 155. For example, the atomic percentage of N in the gate electrode 155 may gradually increase based on a total number of atoms in the gate electrode 155 as it moves away (e.g., the gate electrode) from the gate semiconductor layer 152 (and also away from the junction surface) and then be almost constant. The atomic percentage of N in the gate electrode 155 may increase or remain constant based on a total number of atoms in the gate electrode 155 as a distance from the gate semiconductor layer increases.

The atomic percentage of Ti in the lower part of the gate electrode 155 may be about 40 atomic percent (at%) or more and about 60 at% or less

In an embodiment, the atomic percentage of Ti in the lower part of the gate electrode 155 is about 45 at% or more and about 55 at% or less based on a total number of atoms in the gate electrode 155. For example, the atomic percentage of Ti in the lower part of the gate electrode 155 may be about 50 at% based on a total number of atoms in the gate electrode 155. The atomic percentage of N in the lower part of the gate electrode 155 may be about 40 at% or more and about 60 at% or less based on a total number of atoms in the gate electrode 155. In an embodiment, the atomic percentage of N in the lower part of the gate electrode 155 is about 45 at% or more and about 55 at% or less based on a total number of atoms in the gate electrode 155. For example, the atomic percentage of N in the lower part of the gate electrode 155 may be about 50 at% based on a total number of atoms in the gate electrode 155. In the lower part of the gate electrode 155, the atomic percentage of Ti to the atomic percentage of N may be about 0.67 or more and about 1.5 or less. In an embodiment, the atomic percentage of Ti to the atomic percentage of N in the lower part of the gate electrode 155 is about 0.81 or more and about 1.22 or less. For example, in the lower part of the gate electrode 155, the atomic percentage of Ti to the atomic percentage of N may be about 1. In other words, the amount of Ti and the amount of N in the lower part of the gate electrode 155 may be the same or very similar.

The atomic percentage of Ti in the upper part of the gate electrode 155 may be about 20 at% or more and about 50 at% or less based on a total number of atoms in the gate electrode 155. In an embodiment, the atomic percentage of Ti in the upper part of the gate electrode 155 is about 35 at% or more and about 45 at% or less based on a total number of atoms in the gate electrode 155. The atomic percentage of N in the upper part of the gate electrode 155 may be about 50 at% or more and about 80 at% or less based on a total number of atoms in the gate electrode 155. In an embodiment, the atomic percentage of N in the upper part of the gate electrode 155 is about 50 at% or more and about 60 at% or less based on a total number of atoms in the gate electrode 155. The atomic percentage of Ti to the atomic percentage of N in the upper part of the gate electrode 155 may be about 0.25 or more and about 1 or less. In an embodiment, the atomic percentage of Ti to the atomic percentage of N in the upper part of the gate electrode 155 is about 0.58 or more and about 0.9 or less. The amount of Ti in the upper part of the gate electrode 155 may be lower than that of N.

Above, the case where the gate electrode 155 is made of a material including Ti and N has been described, but is not limited thereto. The gate electrode 155 may further include other materials in addition to Ti and N. For example, the gate electrode 155 may further include O or C. Accordingly, the atomic percentage of Ti to the atomic percentage of N in the gate electrode 155 may also change.

A depletion region DPR may be formed within the channel layer 132 due to the gate semiconductor layer 152. The depletion region DPR may be positioned within the drift region DTR and may have a narrower width than the drift region DTR. The depletion region DRP may correspond to a portion of the channel layer 132 which is overlaid by the gate semiconductor layer 152. In other words, the gate semiconductor layer 152 may (only) overlay the channel layer 132 in the depletion region DRP. Since the gate semiconductor layer 152, which has a different energy band gap from the barrier layer 136, is positioned on the barrier layer 136, the level of the energy band of the portion of the barrier layer 136 that overlaps the gate semiconductor layer 152 may increase. Accordingly, the depletion region DPR may be formed in the region of the channel layer 132 that overlaps the gate semiconductor layer 152. The depletion region DPR may be a region in the channel path of the channel layer 132 in which the 2-dimensional electron gas 134 is not formed or has a lower electron concentration than the remaining regions. In other words, the depletion region DPR may mean a region where the flow of the 2-dimensional electron gas 134 is disconnected within the drift region DTR. When the depletion region DPR occurs, a current does not flow between the source electrode 173 and the drain electrode 175, and the channel path may be blocked. Accordingly, the semiconductor device according to an embodiment may have a normally off characteristic.

That is, the semiconductor device according to an embodiment may be a normally off high electron mobility transistor (HEMT). As shown in FIG. 1, In the normal state in which no voltage is applied to the gate electrode 155, a depletion region DPR exists, and the semiconductor device according to an embodiment may be in an off state. As shown in FIG. 2, when a voltage higher than the threshold voltage is applied to the gate electrode 155, the depletion region DPR disappears, and the 2-dimensional electron gas 134 within the drift region DTR may be connected, i.e., connected between the source electrode 173 and the drain electrode 175. That is, the 2-dimensional electron gas 134 may be formed throughout the channel path between the source electrode 173 and the drain electrode 175, and the semiconductor device according to an embodiment may be turned on. In summary, the semiconductor device according to an embodiment may include semiconductor layers with different electrical polarization characteristics. For example, the semiconductor layer with a relatively high polarization rate may induce the 2-dimensional electron gas 134 in another semiconductor layer heterogeneously jointed thereto. This 2-dimensional electron gas 134 may be used as a channel between the source electrode 173 and the drain electrode 175, and the connection or disconnection between the electrodes 173, 175 via the flow of this 2-dimensional electron gas 134 may be controlled by a bias voltage applied to the gate electrode 155. In the gate off state, the flow of the 2-dimensional electron gas 134 is blocked, so a current does not flow between the source electrode 173 and the drain electrode 175. Since the flow of the 2-dimensional electron gas 134 continues in the gate on state, a current may flow between the source electrode 173 and the drain electrode 175. The gate off state may comprise no voltage being applied to the gate electrode 155, or a voltage being applied to the gate electrode 155 which is below a threshold voltage. The gate on state may comprise the application of a voltage to the gate electrode 155 greater than the threshold voltage.

In the semiconductor device according to an embodiment, the width of the lower part of the gate electrode 155 is smaller than the width of the upper part of the gate electrode 155, and the width of the lower part of the gate electrode 155 is smaller than the width of the gate semiconductor layer 152. In the contact portion (i.e., the contact area/surface or junction area/surface) between the gate electrode 155 and the gate semiconductor layer 152, the width of the gate electrode 155 may be smaller than the width of the gate semiconductor layer 152. Accordingly, at least part of the upper surface of the gate semiconductor layer 152 is not covered by the gate electrode 155, and there may be a portion where the gate semiconductor layer 152 and the gate electrode 155 are spaced apart (i.e., spaced apart in the Z axis or vertical direction). In this way, the portion of the gate semiconductor layer 152 that is not in contact with the gate electrode 155 may act as a resistance component to increase the threshold voltage of the semiconductor device according to an embodiment. Therefore, the problem of the gate electrode 155 not being turned off may be at least partially addressed. Further, the problem of the reliability being deteriorated due to a decrease in the threshold voltage due to an increase in the driving voltage and/or an increase in the surrounding temperature may be solved.

In the above, the case where the semiconductor device according to an embodiment is the normally off high electron mobility transistor has been described, but it is not limited thereto. For example, the semiconductor device according to an embodiment may be a normally-on high electron mobility transistor. In the case of the normally-on high electron mobility transistor, the gate semiconductor layer 152 may be omitted, and thus the gate electrode 155 may be positioned directly on the barrier layer 136. That is, the gate electrode 155 may be in contact with the barrier layer 136. In this structure, the 2-dimensional electron gas 134 may be used as a channel without a voltage being applied to the gate electrode 155, and a current flow may occur between the source electrode 173 and the drain electrode 175. Additionally, when a negative voltage is applied to the gate electrode 155, the depletion region DPR may occur in which the flow of the 2-dimensional electron gas 134 is disconnected under the gate electrode 155. In the semiconductor device according to an embodiment, since the width of the lower part of the gate electrode 155 is smaller than the width of the upper part, it may serve as a field disperse layer that disperses the electric field concentrated around the gate electrode 155. Accordingly, the reliability of the semiconductor device may be secured.

The buffer layer 120, the superlattice layer 124, the high-resistance layer 126, the channel layer 132, the barrier layer 136, and the gate semiconductor layer 152 described above may be sequentially stacked on the substrate 110. In a semiconductor device according to an embodiment, at least one of the buffer layer 120, the superlattice layer 124, the high-resistance layer 126, the channel layer 132, the barrier layer 136, and the gate semiconductor layer 152 may be omitted. The buffer layer 120, the superlattice layer 124, the high-resistance layer 126, the channel layer 132, the barrier layer 136, and the gate semiconductor layer 152 may be made of the same semiconductor based material, and the material composition ratio of each layer may be different considering the role of each layer and the performance required for the semiconductor device.

The semiconductor device according to an embodiment may further include a first protection layer 140 positioned above (e.g., in the Z axis or vertical direction) the barrier layer 136 and the gate semiconductor layer 152. The first protection layer 140 may cover the upper surface of the barrier layer 136 and may cover the upper surface and side surface of the gate semiconductor layer 152. The portion of the gate semiconductor layer 152 that is not covered by the gate electrode 155 may be covered by the first protection layer 140. Additionally, the first protection layer 140 may cover the upper surface and side surface of the gate electrode 155. The first protection layer 140 may be in contact with the barrier layer 136, the gate semiconductor layer 152, and the gate electrode 155. The barrier layer 136, the gate semiconductor layer 152, and the gate electrode 155 may be protected by the first protection layer 140 and may be separated from other components by the first protection layer 140. The first protection layer 140 may include or be an insulating material or an insulator. For example, the first protection layer 140 may include an oxide such as SiO₂ or Al₂O₃. As another example, the first protection layer 140 may include a nitride such as SiN or an oxynitride such as SiON. The first protection layer 140 may be a single layer or multiple layers.

The source electrode 173 and the drain electrode 175 may be positioned above (e.g., in the Z axis or vertical direction) the channel layer 132. The source electrode 173 and the drain electrode 175 may be spaced apart from each other, and the gate electrode 155 and the gate semiconductor layer 152 may be positioned between the source electrode 173 and the drain electrode 175. The gate electrode 155 and the gate semiconductor layer 152 are spaced apart from the source electrode 173 and the drain electrode 175. The source electrode 173 may be electrically connected to the channel layer 132 on one side of the gate electrode 155. The drain electrode 175 may be electrically connected to the channel layer 132 on the other side of the gate electrode 155. In an embodiment, the source electrode 173 and the drain electrode 175 are positioned outside the drift region DTR of the channel layer 132. The interface between the source electrode 173 and the channel layer 132 may be one edge of the drift region DTR. Likewise, the interface between the drain electrode 175 and the channel layer 132 may be the other edge of the drift region DTR. However, the present inventive concept is not limited to this. For example, the source electrode 173 and/or the drain electrode 175 may be positioned inside the drift region DTR of the channel layer 132. In an embodiment, the channel layer 132 is not recessed, and the source electrode 173 and the drain electrode 175 may be positioned on the upper surface of the channel layer 132. In an embodiment, the barrier layer 136 is not penetrated, and a portion of the barrier layer 136 is recessed, so that the source electrode 173 and the drain electrode 175 may be positioned on the upper surface of the barrier layer 136. The bottom surface of the source electrode 173 and the drain electrode 175 may be in contact with the upper surface of the channel layer 132. The portion of the channel layer 132 in contact with the source electrode 173 and the drain electrode 175 may be doped at a high concentration. At this time, the carrier passing through the 2-dimensional electron gas 134 may pass through the portion of the channel layer 132 doped at high concentration, that is, the upper part of the 2-dimensional electron gas 134, and be transmitted to the source electrode 173 and the drain electrode 175. The source electrode 173 and the drain electrode 175 may be not in direct contact with the 2-dimensional electron gas 134 in the horizontal direction. The horizontal direction may mean a direction parallel to the upper surface of the channel layer 132 or the barrier layer 136.

The source electrode 173 and the drain electrode 175 may be positioned above (e.g., in the Z axis or vertical direction) the first protection layer 140. A trench that penetrates the first protection layer 140 and the barrier layer 136 and recesses the upper surface of the channel layer 132 may be positioned on both sides of the gate electrode 155 to be spaced apart from each other. The source electrode 173 and the drain electrode 175 may be positioned within the trench positioned on both sides of the gate electrode 155, respectively. The source electrode 173 and the drain electrode 175 may be formed to fill the trench. Within the trench, the source electrode 173 and the drain electrode 175 may be in contact with the channel layer 132 and the barrier layer 136. The channel layer 132 may form the bottom surface and sidewall of the trench, and the barrier layer 136 may form the sidewall of the trench. Accordingly, the source electrode 173 and the drain electrode 175 may be in contact with the upper surface and side surface of the channel layer 132. Additionally, the source electrode 173 and the drain electrode 175 may be in contact with the side surface of the barrier layer 136. That is, the source electrode 173 and the drain electrode 175 may cover or overlay the sides of the channel layer 132 and the barrier layer 136. The upper surface of the source electrode 173 and the drain electrode 175 may protrude from the upper surface of the first protection layer 140. In some cases, at least one of the source electrode 173 and the drain electrode 175 may cover or overlay at least a portion of the upper surface of the first protection layer 140.

The source electrode 173 and the drain electrode 175 may include a conductive material or be a conductor. For example, the source electrode 173 and the drain electrode 175 may include a metal, a metal alloy, a conductive metal nitride, a metal silicide, a doped semiconductor material, a conductive metal oxide, or a conductive metal oxynitride. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonizationnitride (TiAIC-N), titanium aluminum carbide (TiAIC), titanium carbide (TiC), tantalum carbonizationnitride (TaCN), tungsten(W), aluminum (Al), copper(Cu), cobalt(Co), titanium (Ti), tantalum (Ta), nickel(Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (lr), osmium (Os), silver (Ag), gold (Au), zinc (Zn), vanadium (V), or combination thereof, but it is not limited thereto. The source electrode 173 and the drain electrode 175 may be a single layer or multiple layers. The source electrode 173 and the drain electrode 175 may be in ohmic contact with the channel layer 132. The region in contact with the source electrode 173 and the drain electrode 175 within the channel layer 132 may be doped at a relatively high concentration compared to other regions.

The semiconductor device according to an embodiment may further include a field dispersion layer positioned above (e.g., in the Z axis or vertical direction) the first protection layer 140. The field dispersion layer can be positioned between (e.g., in the X or Y axis or horizontal direction) source electrode 173 and drain electrode 175. The field dispersion layer may overlap with or overlay the gate electrode 155 in the vertical direction. The gate electrode 155 may be covered by the field dispersion layer. The field dispersion layer may be electrically connected to the source electrode 173. The field dispersion layer may include the same material as the source electrode 173 and may be positioned in the same layer as the source electrode 173. The field dispersion layer may be formed simultaneously using the same process as the source electrode 173. The boundary between the field dispersion layer and the source electrode 173 may not be distinct, and thus the field dispersion layer may be formed integrally with the source electrode 173. However, it is not limited to this, and the field dispersion layer may be a component separate from the source electrode 173. Additionally, the field dispersion layer may be positioned in a different layer from the source electrode 173 and may be formed using a different process. In some cases, the field dispersion layer may be electrically connected to the gate electrode 155. For example, an opening that overlaps the gate electrode 155 may be formed in the first protection layer 140, and the field dispersion layer may be connected to the gate electrode 155 through the opening. At this time, the field dispersion layer may not be connected to the source electrode 173.

The field dispersion layer may serve to disperse the electric field concentrated around the gate electrode 155. If a high voltage is applied to the drain electrode 175 in the gate off state, an electric field may be concentrated around the gate electrode 155. If the electric field is concentrated on the gate electrode 155, a leakage current may increase and a breakdown voltage may decrease. The electric field concentrated around the gate electrode 155 may be dispersed by the field dispersion layer, thereby reducing the leakage current and increasing the breakdown voltage.

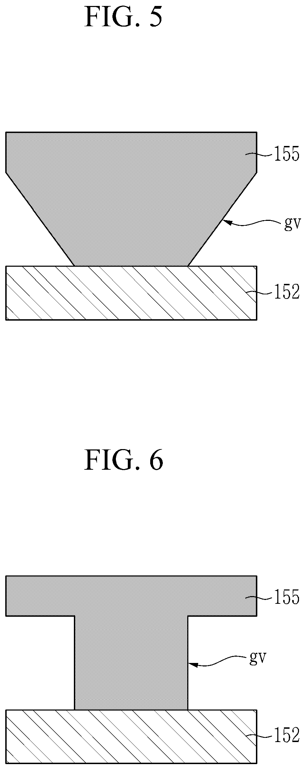

The cross-section shape of the gate electrode 155 of the semiconductor device according to an embodiment may be changed in various ways, and numerous variations of the shape of the gate electrode 155 are described with reference to FIG. 5 to FIG. 12.

FIG. 5 to FIG. 12 are cross-sectional views showing some layers of a semiconductor device according to an embodiment. FIG. 5 to FIG. 12 show the gate semiconductor layer and the gate electrode of the semiconductor device according to an embodiment.

As shown in FIG. 5, a gate electrode 155 of the semiconductor device according to an embodiment includes a groove gv. The groove gv may have a triangular shape in the cross-section. The inclined surface of the gate electrode 155 constituting the groove gv may have a predetermined inclined angle with respect to the upper surface of the gate semiconductor layer 152. In an embodiment, the inclination angle of the inclined surface of the gate electrode 155 is constant or is an acute angle. That is, the gate electrode 155 may have a reverse taper shape. The width of the upper part of the gate electrode 155 may be constant, and from a predetermined point, the width of gate electrode 155 may gradually decrease as it approaches the gate semiconductor layer 152. The gate electrode 155 of FIG. 5 may include a rectangle shape and a trapezoid shape in a cross-section.

As shown in FIG. 6, the groove gv of the gate electrode 155 of the semiconductor device according to an embodiment has a square shape in a cross-section. The side surface of the gate electrode 155 constituting the groove gv may be perpendicular to the upper surface of the gate semiconductor layer 152. The gate electrode 155 may be divided into two parts depending on the difference in the width. In an embodiment, the width of the lower part of gate electrode 155 is smaller than the width of the upper part. The width of the lower part of the gate electrode 155 may be constant, and the width of the upper part may be constant. For example, the gate electrode 155 of FIG. 6 may include a rectangle shape and a square shape in a cross-section having a smaller width than the rectangle shape.

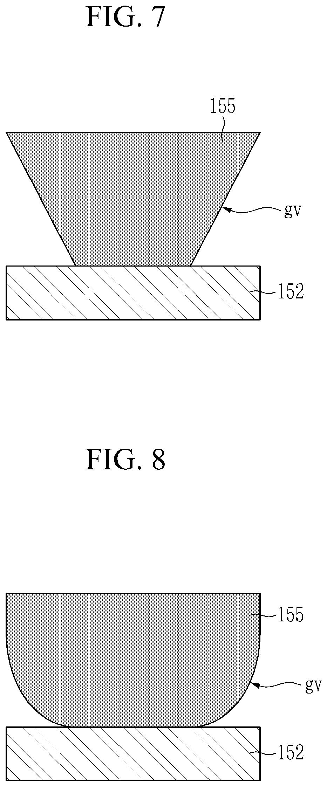

As shown in FIG. 7, the groove gv of the gate electrode 155 of the semiconductor device according to an embodiment has a triangular shape in a cross-section. The gate electrode 155 may have a reverse taper shape. The width of the gate electrode 155 may gradually decrease from the upper part toward the lower part. In other words, the width of gate electrode 155 may gradually decrease as it approaches the gate semiconductor layer 152. The gate electrode 155 does not include a portion where the width is constant. The gate electrode 155 of FIG. 7 may include a trapezoid shape in a cross-section.

As shown in FIG. 8, the groove gv of the gate electrode 155 of the semiconductor device according to an embodiment includes a curved surface. The groove gv may have a concave curved surface shape. The slope of the side surface of the gate electrode 155 with respect to the gate semiconductor layer 152 within the groove gv may gradually decrease as it approaches the gate semiconductor layer 152. For example, the slope of the side surface of gate electrode 155 within the groove gv may range from about 90 degrees to about 0 degrees. In the area close to the gate semiconductor layer 152, the slope of the side surface of the gate electrode 155 may be close to 0 degrees.

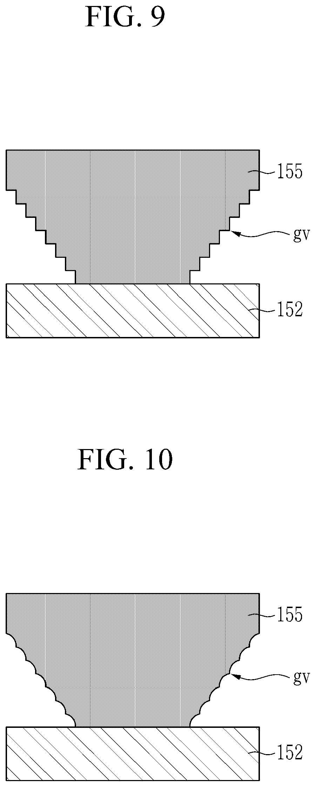

As shown in FIG. 9, the groove gv of the gate electrode 155 of the semiconductor device according to an embodiment has one or more step shapes. The surface of the gate electrode 155 constituting the groove gv may have a step shape. The width of the upper part of gate electrode 155 may be constant, and from a predetermined point, the width of gate electrode 155 may gradually decrease in stages as it approaches the gate semiconductor layer 152. The number of the steps in which the width of gate electrode 155 decreases may be varied. Additionally, the thickness of the gate electrode 155 corresponding to each stage may be constant, or the thickness of the gate electrode 155 may be different in at least some stages.

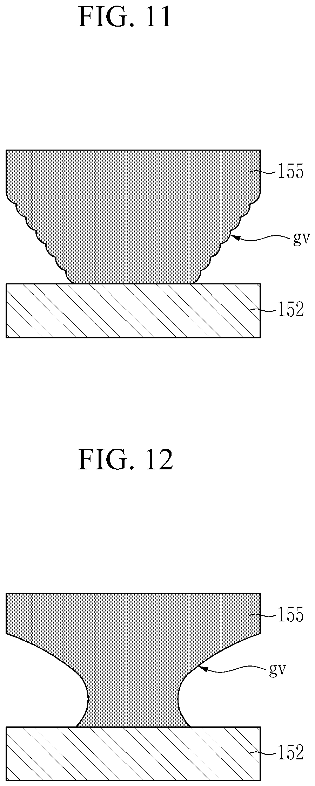

As shown in FIG. 10 and FIG. 11, the groove gv of the gate electrode 155 of the semiconductor device according to an embodiment has an approximate step shape. At this time, each step may have a convex curved surface shape or a concave curved surface shape. The width of the upper part of gate electrode 155 may be constant, and from a predetermined point, the width of the gate electrode 155 gradually decreases in stages as it approaches the gate semiconductor layer 152, but within each step, the width of the gate electrode 155 may gradually decrease.

As shown in FIG. 12, the groove gv of the gate electrode 155 of the semiconductor device according to an embodiment includes a curved surface. In the previous embodiment, the point where the width of the gate electrode 155 is minimum may be the part in contact with the gate semiconductor layer 152 (i.e., the junction surface). In the present embodiment, the width of the gate electrode 155 in contact with the gate semiconductor layer 152 may not be minimum. The point where the width of the gate electrode 155 is minimum may be a part away from the gate semiconductor layer 152 by a predetermined distance. The width of the upper part of gate electrode 155 may be constant, and from a predetermined point, the width of the gate electrode 155 may decrease as it approaches the gate semiconductor layer 152 and then increase again. In an embodiment, the width of the gate electrode 155 in contact with the gate semiconductor layer 152 is smaller than the width of the gate semiconductor layer 152.

In the above, various cross-section shapes of the gate electrode of the semiconductor device according to an embodiment have been described, but they are not limited thereto.

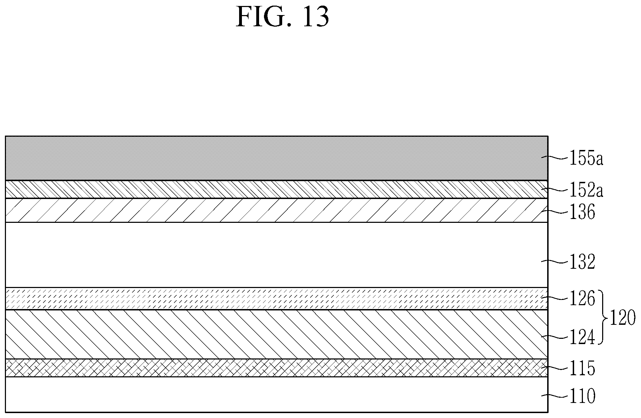

Next, a method of manufacturing a semiconductor device according to an embodiment is described with reference to FIG. 13 to FIG. 17.

FIG. 13 to FIG. 17 are process cross-sectional views showing a semiconductor device according to an embodiment according to a manufacturing process order.

First, as shown in FIG. 13, a seed layer 115, a buffer layer 120, a channel layer 132, a barrier layer 136, a gate semiconductor material layer 152a, and a gate electrode material layer 155a are sequentially formed on a substrate 110.

The substrate 110 may include or be a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited to this, and any generally-used substrate may be applied.

The seed layer 115, the buffer layer 120, the channel layer 132, the barrier layer 136, and the gate semiconductor material layer 152a may be formed sequentially using an epitaxial growth method. The seed layer 115 may be formed first on the substrate 110, and the buffer layer 120 may be formed on the seed layer 115. The buffer layer 120 may include a superlattice layer 124 and a high-resistance layer 126. The channel layer 132 may be formed on the buffer layer 120, the barrier layer 136 may be formed on the channel layer 132, and the gate semiconductor material layer 152a may be formed on the barrier layer 136.

The seed layer 115, the buffer layer 120, the channel layer 132, the barrier layer 136, and the gate semiconductor material layer 152a may be made of the same semiconductor based material. However, the material composition ratio of each layer may be different considering the role of each layer and the performance required for the semiconductor device. The seed layer 115, buffer layer 120, the channel layer 132, the barrier layer 136, and the gate semiconductor material layer 152a may include one or more materials selected from Group III-V materials, for example, nitrides at least one among Al, Ga, In, and B. The seed layer 115, the buffer layer 120, the channel layer 132, the barrier layer 136, and the gate semiconductor material layer 152a may be AlₓIn_{y}Ga_{(1-x-y)}N (0≤x≤1, 0≤y≤1, x+y≤1). The seed layer 115, the buffer layer 120, the channel layer 132, the barrier layer 136, and the gate semiconductor material layer 152a may include at least one of AIN, GaN, InN, InGaN, AlGaN, AllnN, and AllnGaN. The barrier layer 136 may include a material having a different energy band gap from the channel layer 132. The barrier layer 136 may have a higher energy band gap than the channel layer 132. The gate semiconductor material layer 152a may include a material having a different energy band gap than the barrier layer 136.

As an example, the substrate 110 includes Si, the seed layer 115 includes AIN, and the superlattice layer 124 may have a structure in which a layer made of AlGaN and a layer made of GaN are repeatedly stacked. The high-resistance layer 126 may include or be GaN, the channel layer 132 may include or be GaN, and the barrier layer 136 may include or be AlGaN. The channel layer 132 and the barrier layer 136 may or may not be impurity doped. The gate semiconductor material layer 152a may include or be GaN and may be doped with an impurity. The gate semiconductor material layer 152a may be doped with a P-type impurity, for example, magnesium (Mg).

Since the lattice structure of Si and the lattice structure of GaN are different, it may not be easy to grow the channel layer 132 made of GaN directly on the substrate 110 made of Si. In a method of manufacturing the semiconductor device according to an embodiment, the seed layer 115 and the buffer layer 120 are first formed on the substrate 110, and then the channel layer 132 is formed, so that the lattice structure of the channel layer 132 may be stably formed.

Subsequently, a gate electrode material layer 155a may be formed on the gate semiconductor material layer 152a. The gate semiconductor material layer 152a is positioned between barrier layer 136 and gate electrode material layer 155a.

The gate electrode material layer 155a may be formed using a deposition process. For example, the gate electrode material layer 155a may be formed using at least one of a physical vapor deposition (PVD), a thermal chemical vapor deposition (a thermal CVD), a low pressure chemical vapor deposition (LP-CVD), a plasma enhanced chemical vapor deposition (PE-CVD), or an atomic layer deposition (ALD) technologies, but it is not limited thereto.

The gate electrode material layer 155a may include or be a conductive material, or be a conductor. For example, the gate electrode material layer 155a may include a metal, a metal alloy, a conductive metal nitride, a metal silicide, a doped semiconductor material, a conductive metal oxide, or a conductive metal oxynitride, the like. For example, the gate electrode material layer 155a may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonizationnitride (TiAIC-N), titanium aluminum carbide (TiAIC), titanium carbide (TiC), tantalum carbonizationnitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium( Os), silver (Ag), gold (Au), zinc (Zn), vanadium (V), or combination thereof, but it is not limited thereto. The gate electrode material layer 155a may be a single layer or multiple layers.

The atomic percentage of the materials constituting the gate electrode material layer 155a within the gate electrode material layer 155a may vary depending on the position. The atomic percentage of the materials constituting the gate electrode material layer 155a may vary depending on the distance from the gate semiconductor material layer 152a. For example, the gate electrode material layer 155a may include TiN, and the atomic percentage of Ti to the atomic percentage of N in the gate electrode material layer 155a may be different depending on the distance from the gate semiconductor material layer 152a. The atomic percentage of Ti in the gate electrode material layer 155a may tend to decrease with the distance from the gate semiconductor material layer 152a based on a total number of atoms in the gate electrode material layer 155a. The atomic percentage of Ti in the gate electrode material layer 155a may tend to decrease from the lower part toward the upper part based on a total number of atoms in the gate electrode material layer 155a. The atomic percentage of Ti in the gate electrode material layer 155a may be constant in at least some regions of the gate electrode material layer 155a based on a total number of atoms in the gate electrode material layer 155a. For example, the atomic percentage of Ti in the gate electrode material layer 155a may gradually decrease as it moves away from the gate semiconductor material layer 152a and then remain constant or substantially constant. The atomic percentage of Ti in the lower part of the gate electrode material layer 155a may be about 40 at% or more and about 60 at% or less based on a total number of atoms in the gate electrode material layer 155a, and gradually decreases as it moves away from the gate semiconductor material layer 152a, so that the atomic percentage of Ti in the lower part of the gate electrode material layer 155a may be about 20 at% or more and about 50 at% or less based on a total number of atoms in the gate electrode material layer 155a. The atomic percentage of N in the gate electrode material layer 155a may tend to increase based on a total number of atoms in the gate electrode material layer 155a as it moves away from the gate semiconductor material layer 152a. The atomic percentage of N in the gate electrode material layer 155a may tend to increase from the lower part toward the upper part based on a total number of atoms in the gate electrode material layer 155a. The atomic percentage of N may be constant in at least some regions of the gate electrode material layer 155a based on a total number of atoms in the gate electrode material layer 155a. For example, the atomic percentage of N in the gate electrode material layer 155a may gradually increase as it moves away from the gate semiconductor material layer 152a and then remain constant or substantially constant based on a total number of atoms in the gate electrode material layer 155a. The atomic percentage of N in the lower part of the gate electrode material layer 155a may be about 40 at% or more and about 60 at% or less based on a total number of atoms in the gate electrode material layer 155a, and gradually increase as it moves away from the gate semiconductor material layer 152a, so that the atomic percentage of N in the upper part of the gate electrode material layer 155a may be about 50 at% or more and about 80 at% or less based on a total number of atoms in the gate electrode material layer 155a. In the process of forming the gate electrode material layer 155a, the atomic percentage of the materials constituting the gate electrode material layer 155a may be changed by controlling a flow rate of Nitrogen (N₂) gas. For example, in the process of forming the gate electrode material layer 155a, the flow rate of N₂ gas may be gradually increased.

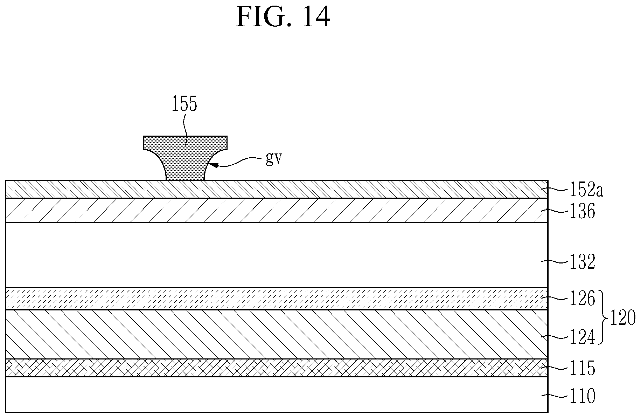

Then, by patterning the gate electrode material layer 155a, as shown in FIG. 14, the gate electrode 155 may be formed. At this time, the gate electrode material layer 155a may be patterned using a dry etching process or a dry etching process.

Parts with the different composition ratios of the materials constituting the gate electrode material layer 155a may have different etching rates in the etching process. For example, the larger the atomic percentage of Ti, the higher the etching ratio may be, and the larger the atomic percentage of N, the smaller the etching ratio. In an embodiment, the atomic percentage of Ti may decrease and the atomic percentage of N may increase as the gate electrode material layer 155a moves from the lower part to the upper part. Therefore, the etching ratio of the lower part and the upper part of the gate electrode material layer 155a may be different. For example, the etching ratio of the lower part of the gate electrode material layer 155a may be greater than the etching ratio of the upper part. In other words, if the etching proceeds for the same amount of time, the lower part of the gate electrode material layer 155a may be etched relatively more than the upper part.

Due to these etching characteristics, the width of the lower part of gate electrode 155 may be relatively smaller than the width of the upper part. Additionally, the difference between the width of the lower part of the gate electrode 155 and the width of the upper part of the gate electrode 155 may be made larger through over-etching, changing the condition of the etching gas, adjusting a bias, etc. The width of the gate electrode 155 may gradually increase and then become constant from the lower part toward the upper part. The gate electrode 155 may include a groove gv that is recessed from the bottom surface and the side surface. The shape of the groove gv of the gate electrode 155 may be changed in various ways as described above. The shape of the groove gv may be formed in various ways depending on the type of the material constituting the gate electrode material layer 155a, the composition ratio, the etching process condition, etc.

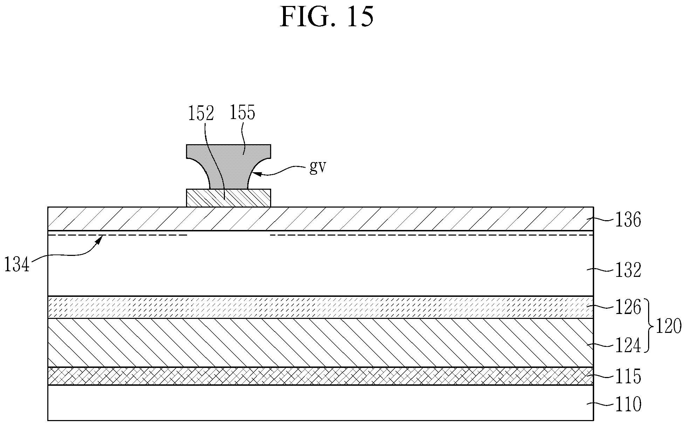

Then, by patterning the gate semiconductor material layer 152a of FIG. 14, as shown in FIG. 15, a gate semiconductor layer 152 can be formed. At this time, the gate semiconductor material layer 155a may be patterned using a dry etching process. The gate semiconductor layer 152 is positioned between the barrier layer 136 and the gate electrode 155. The gate electrode 155 may be in Schottky contact or ohmic contact to the gate semiconductor layer 152.

To minimize damage to the barrier layer 136 in the process of etching the gate semiconductor material layer 152a, a selective etching process condition having a difference in the etch rate of the gate semiconductor material layer 152a and the barrier layer 136 may be used. For example, while the barrier layer 136 made of AlGaN is hardly etched, the gate semiconductor material layer 152a made of p-GaN may be easily etched. At this time, a surface oxidation etching method may be used by adding oxygen (O₂) to the etching gas. Accordingly, if the barrier layer 136 is not damaged and has a predetermined thickness, the channel layer 132 may have a high current density.

The gate semiconductor material layer 152a can be patterned using the hard mask pattern remaining on the gate electrode 155 or the gate electrode 155. Therefore, the gate semiconductor layer 152 may have a pattern similar to that of the gate electrode 155. That is, the gate semiconductor layer 152 and the gate electrode 155 may have substantially the same planar shape. In the cross-section, the width of the gate semiconductor layer 152 may be substantially the same as the maximum width of the gate electrode 155, but is not limited to this, and the width of the gate semiconductor layer 152 may be less than or equal to the maximum width of the gate electrode 155. The width of the gate semiconductor layer 152 may be substantially the same as the width of the upper part of the gate electrode 155, but is not limited to this. For example, the width of the gate semiconductor layer 152 may be smaller than or equal to the width of the upper part of the gate electrode 155. The width of the gate semiconductor layer 152 is shown as constant, but it is not limited to this and may have a normal taper shape in some cases.

In the semiconductor device according to an embodiment, the width of the lower part of the gate electrode 155 is smaller than the width of the upper part of the gate electrode 155, and the width of the lower part of the gate electrode 155 is smaller than the width of the gate semiconductor layer 152. In the contact portion between the gate electrode 155 and the gate semiconductor layer 152, the width of the gate electrode 155 may be smaller than the width of the gate semiconductor layer 152. Accordingly, at least part of the upper surface of the gate semiconductor layer 152 may be not covered by the gate electrode 155, and there may be a portion where the gate semiconductor layer 152 and the gate electrode 155 are spaced apart. In this way, the portion of the gate semiconductor layer 152 that is not in contact with the gate electrode 155 may act as a resistance component, thereby increasing the threshold voltage of the semiconductor device according to an embodiment. Therefore, a problem of the gate not being turned off, or the reliability being deteriorated as the threshold voltage is lower due to an increase in the driving voltage or an increase in the surrounding temperature may be at least partially addressed.

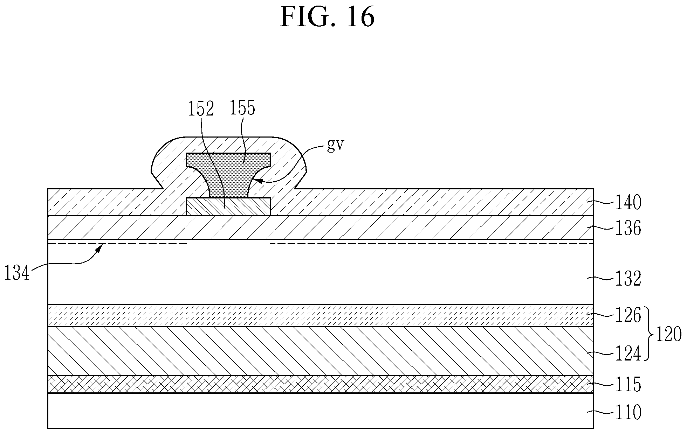

As shown in FIG. 16, a first protection layer 140 may be formed on the barrier layer 136, the gate semiconductor layer 152, and the gate electrode 155.

The first protection layer 140 may be formed using a deposition process. The first protection layer 140 may include or be an insulating material or an insulator. For example, the first protection layer 140 may include materials such as SiO2, SiN, SiON, Al2O3, etc. The first protection layer 140 is shown as a single layer, but in some embodiments it may be comprised of multiple layers. At this time, different materials may be deposited sequentially to form the first protection layer 140. Alternatively, by using the same material and varying the deposition conditions, the first protection layer 140 consisting of several layers with different characteristics may be formed. The part of the first protection layer 140 adjacent to the barrier layer 136 may be made of an insulating material of a much better quality than other parts. This is to prevent electrons forming a channel from being trapped within the channel layer 132 positioned below the barrier layer 136. For example, the portion of the first protection layer 140 that is in contact with the barrier layer 136 may be made of SiO₂.

The upper surface of the barrier layer 136 may be covered by the first protection layer 140. The upper and side surfaces of the gate semiconductor layer 152 may be covered by the first protection layer 140. The portion of the gate semiconductor layer 152 that is not covered by the gate electrode 155, that is, the edge of the upper surface of the gate semiconductor layer 152, may be covered by the first protection layer 140. The upper and side surfaces of the gate electrode 155 may be covered by the first protection layer 140. The groove gv of the gate electrode 155 may be filled by the first protection layer 140. A step may be present between the portion of the first protection layer 140 that overlaps with the gate electrode 155 and the gate semiconductor layer 152 and the remaining portion. However, it is not limited to this, and in some embodiments, the upper surface of the first protection layer 140 may be entirely flat. For example, if the thickness of the first protection layer 140 is relatively thick, a step should not be present between the portion of the first protection layer 140 that overlaps the gate electrode 155 and the gate semiconductor layer 152 and the remaining portion. In this embodiment, the first protection layer 140 may have a uniform thickness.

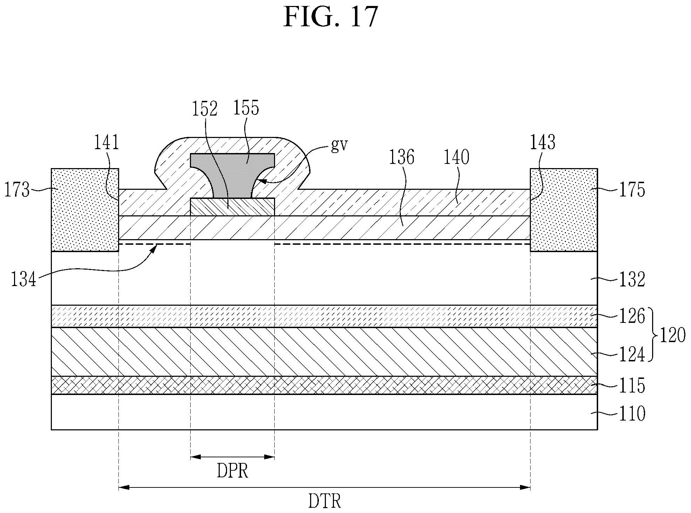

As shown in FIG. 17, by patterning the first protection layer 140, a first trench 141 and a second trench 143 may be formed. At this time, not only the first protection layer 140 but also the barrier layer 136 and the channel layer 132 may be patterned together.

For example, a photoresist pattern may be formed on the first protection layer 140, and the first protection layer 140, the barrier layer 136, and the channel layer 132 may be sequentially etched using the photoresist pattern as a mask. At this time, the first protection layer 140 and the barrier layer 136 may be penetrated by the first trench 141 and the second trench 143, and the upper surface of the channel layer 132 may be recessed. The channel layer 132 need not be penetrated by the first trench 141 or the second trench 143. That is, the depth at which the upper surface of the channel layer 132 is recessed may be smaller than the entire thickness of the channel layer 132. At this time, the depth at which the upper surface of the channel layer 132 is recessed may be much smaller than the entire thickness of the channel layer 132. For example, the depth at which the upper surface of the channel layer 132 is recessed may be about 0% to about 30% of the entire thickness of the channel layer 132. Additionally, the depth at which the upper surface of the channel layer 132 is recessed may be smaller than the thickness of the barrier layer 136. However, it is not limited to this, and the depth at which the upper surface of the channel layer 132 is recessed may vary, and in some embodiments, the upper surface of the channel layer 132 need not be recessed. The sides of the first protection layer 140 and the barrier layer 136 may be exposed to the outside by the first trench 141 and the second trench 143, and the top and side surfaces of the channel layer 132 may be exposed. The channel layer 132 may form the bottom surface and sidewall of the first trench 141 and the second trench 143, and the barrier layer 136 may form the sidewall of the first trench 141 and the second trench 143.

The first trench 141 and the second trench 143 may be spaced apart from each other, e.g., in the X or Y axis, or horizontal direction. The first trench 141 to one side (e.g., to the left of) of the gate electrode 155 and the second trench 143 may be positioned to another side (e.g., to the right of) of the gate electrode 155. The first trench 141 may be positioned on one side (e.g., left side) of the gate electrode 155 to be spaced apart from the gate electrode 155. The second trench 143 may be positioned on the other side (e.g., right side) of the gate electrode 155 to be spaced apart from the gate electrode 155. The distance that the first trench 141 is separated from the gate electrode 155 may be smaller than the distance that the second trench 143 is separated from the gate electrode 155. The shapes such as the widths and the depths of first trench 141 and the second trench 143 are shown to be similar, but are not limited thereto. The shapes of the first trench 141 and the second trench 143 may be changed in various ways.

Next, a conductive material or a conductor is deposited on the first protection layer 140 on which the first trench 141 and the second trench 143 are formed, and patterned to form a source electrode 173 and a drain electrode 175.

The source electrode 173 and the drain electrode 175 may include a conductive material or be conductor. For example, the source electrode 173 and the drain electrode 175 may include a metal, a metal alloy, a conductive metal nitride, a metal silicide, a doped semiconductor material, a conductive metal oxide, or a conductive metal oxynitride. The source electrode 173 and the drain electrode 175 may be a single layer or multiple layers. For example, a plurality of conductive layers including different materials may be stacked and then patterned to form the source electrode 173 and the drain electrode 175. At this time, the plurality of conductive layers may be etched simultaneously or sequentially using one mask pattern.

The source electrode 173 may be formed to fill the interior of the first trench 141. Within the first trench 141, the source electrode 173 may be in contact with the channel layer 132 and the barrier layer 136. The source electrode 173 may be in contact with the side surfaces of the channel layer 132 and the barrier layer 136. The source electrode 173 may cover the sides of the channel layer 132 and the barrier layer 136. The source electrode 173 may be electrically connected to the channel layer 132 through the first trench 141. The upper surface of the source electrode 173 may protrude from the upper surface of the first protection layer 140.

The drain electrode 175 may be formed to fill the interior of the second trench 143. Within the second trench 143, the drain electrode 175 may be in contact with the channel layer 132 and the barrier layer 136. The drain electrode 175 may be in contact with the sides of the channel layer 132 and the barrier layer 136. The drain electrode 175 may cover the sides of the channel layer 132 and the barrier layer 136. The drain electrode 175 may be electrically connected to the channel layer 132 through the second trench 143. The upper surface of the drain electrode 175 may be more protruded than the upper surface of the first protection layer 140.

The source electrode 173 and the drain electrode 175 may be in ohmic contact with the channel layer 132. The region in contact with the source electrode 173 and the drain electrode 175 within the channel layer 132 may be doped at a relatively high concentration compared to other regions. For example, the channel layer 132 may be doped by an ion implant process or an annealing process. However, it is not limited to this, and the doping process of the channel layer 132 may be comprised of various other processes. The doping process of the channel layer 132 may be performed before forming the source electrode 173 and the drain electrode 175. In some embodiments, the channel layer 132 is not doped.

Inside the channel layer 132, a 2-dimensional electron gas 134 may be formed in the portion adjacent to the barrier layer 136. The 2-dimensional electron gas 134 may be positioned at the interface between the channel layer 132 and the barrier layer 136. The 2-dimensional electron gas 134 may be positioned in a drift region DTR between the source electrode 173 and the drain electrode 175. A depletion region DPR may be formed within the channel layer 132 by the gate semiconductor layer 152 having a different energy band gap from the barrier layer 136. Accordingly, the semiconductor device according to an embodiment may have a normally off characteristic. That is, the semiconductor device according to an embodiment may be a normally off high electron mobility transistor (HEMT). In the gate off state, the 2-dimensional electron gas 134 can be positioned within the drift region DTR excluding the depletion region DPR of the channel layer 132. In the gate-on state, the flow of the 2-dimensional electron gas 134 continues within the depletion region DPR, allowing the 2-dimensional electron gas 134 to be positioned overall within the drift region DTR.

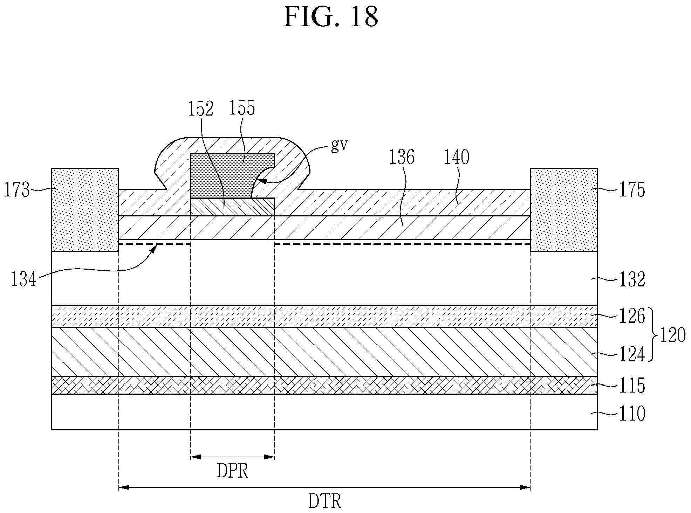

Next, a semiconductor device according to an embodiment is described with reference to FIG. 18.

FIG. 18 is a cross-sectional view showing a semiconductor device according to an embodiment.

The many parts of the embodiment shown in FIG. 18 are the same as the embodiment shown in FIG. 1 so that the description thereof will be omitted and the differences will be mainly explained. Additionally, the same reference numerals are used for the same components as the previous embodiment. The embodiment shown in FIG. 18 is slightly different from the previous embodiment in that the groove of the gate electrode is formed only on one side of the gate electrode.

As shown in FIG. 18, the gate electrode 155 of the semiconductor device according to an embodiment includes the groove gv.

In the previous embodiment, the groove gv is positioned on both edges of the gate electrode 155, and in the present embodiment, the groove gv is positioned only on one edge of the gate electrode 155. For example, it may be positioned only on the right edge among the left and right edges of the gate electrode 155. At this time, the left edge of the gate electrode 155 may be adjacent to the source electrode 173, and the right edge of the gate electrode 155 may be adjacent to the drain electrode 175. That is, the groove gv may be formed at the edge of the gate electrode 155 adjacent to the drain electrode 175. In this embodiment, the groove gv is not formed at the edge of the gate electrode 155 adjacent to the source electrode 173. Since the groove gv is formed in the portion of the gate electrode 155 adjacent to the drain electrode 175 receiving a relatively high voltage, the electric field concentrated around the gate electrode 155 may be dispersed. However, it is not limited to this, and the groove gv may be formed at the edge of the gate electrode 155 adjacent to the source electrode 173. The shape of the groove gv of the gate electrode 155 may be changed in various ways as described above. In a cross-section, the width of the upper part of the gate electrode 155 and the width of the semiconductor layer 152 are shown to be the same, but this is not limited to this, and the upper part of the gate electrode 155 may be larger than the width of the semiconductor layer 152 and be extended to overlap with the drift region DTR positioned outside the depletion region DPR in the vertical direction.

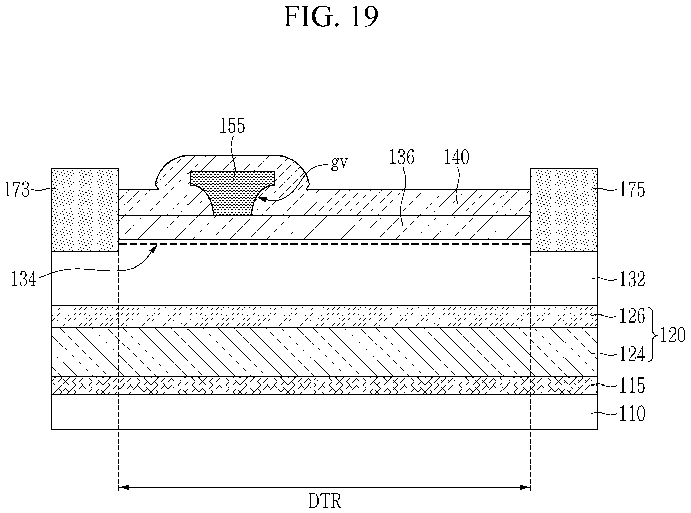

Next, a semiconductor device according to an embodiment is described with reference to FIG. 19.

FIG. 19 is a cross-sectional view showing a semiconductor device according to an embodiment.

Many parts of the embodiment shown in FIG. 19 are the same as the embodiment shown in FIG. 1 so that any redundant description thereof will be omitted and the differences will be mainly explained. Additionally, the same reference numerals are used for the same components as the previous embodiment. The embodiment shown in FIG. 19 is slightly different from the previous embodiment in that the gate semiconductor layer is omitted.

As shown in FIG. 19, the semiconductor device according to an embodiment includes a channel layer 132, a barrier layer 136 positioned on the channel layer 132, a gate electrode 155 positioned on the barrier layer 136, and a source electrode 173 and a drain electrode 175 spaced from each other on the channel layer 132.

In the previous embodiment, the gate semiconductor layer is positioned between the barrier layer 136 and the gate electrode 155, but in the present embodiment, the gate semiconductor layer is not positioned between the barrier layer 136 and the gate electrode 155. For example, the gate semiconductor layer is omitted. The gate electrode 155 may be positioned directly on the barrier layer 136. The bottom surface of the gate electrode 155 may be in contact with the upper surface of the barrier layer 136. However, it is not limited to this, and a capping layer may be positioned between the barrier layer 136 and the gate electrode 155. The capping layer may include or be GaN and may have a thickness of several nm. The 2-dimensional electron gas 134 may be used as a channel without a voltage being applied to the gate electrode 155, and a current flow may occur between the source electrode 173 and the drain electrode 175. The semiconductor device according to the present embodiment may be a normally-on high electron mobility transistor.

The gate electrode 155 of the semiconductor device according to an embodiment includes at least one groove gv, and the shape of the groove gv may be changed in various ways as described above. At least a portion of the gate electrode 155 may be separated from the barrier layer 136 by the groove gv. The shape of the gate electrode 155 may help to control the electric field concentrated on the edge of the gate electrode 155, thereby increasing the reliability of the semiconductor device.

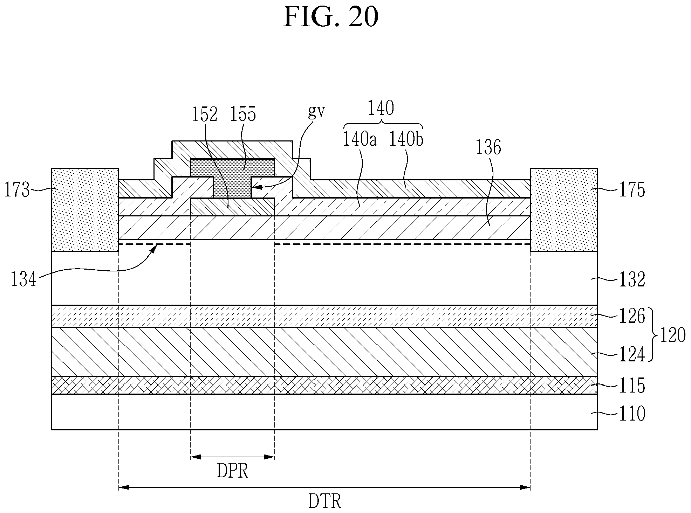

Next, a semiconductor device according to an embodiment is described with reference to FIG. 20,

FIG. 20 is a cross-sectional view showing a semiconductor device according to an embodiment.

Many parts of the embodiment shown in FIG. 20 are the same as the embodiment shown in FIG. 1 so that any redundant description thereof will be omitted and the differences will be mainly explained. Additionally, the same reference numerals are used for the same components as the previous embodiment. The embodiment shown in FIG. 20 is slightly different from the previous embodiment in that the first protective layer includes a first lower protection layer and a first upper protective layer.

As shown in FIG. 20, the first protection layer 140 is positioned on the barrier layer 136 and the gate semiconductor layer 152. The first protection layer 140 includes a first lower protection layer 140a and a first upper protection layer 140b. The first upper protection layer 140b is positioned above the first lower protection layer 140a.

The first lower protection layer 140a may cover or overlay the upper surface of the barrier layer 136 and the upper and side surfaces of the gate semiconductor layer 152. The portion of the gate semiconductor layer 152 that is not covered by the gate electrode 155 may be covered by the first lower protection layer 140a. Additionally, the first lower protection layer 140a may cover a portion of the side surface of the gate electrode 155. The first lower protection layer 140a may be in contact with the barrier layer 136, the gate semiconductor layer 152, and the gate electrode 155. The gate electrode 155 includes at least one groove gv, and the groove gv of the gate electrode 155 is filled by the first lower protection layer 140a. In the area where the gate electrode 155 and the gate semiconductor layer 152 are separated, the first lower protection layer 140a may be positioned between the gate electrode 155 and the gate semiconductor layer 152.

The first upper protection layer 140b is positioned above the first lower protection layer 140a and the gate electrode 155. The first upper protection layer 140b may cover or overlay the upper surface and a part of the side surface of the gate electrode 155. The first upper protection layer 140b may be in contact with the first lower protection layer 140a and the gate electrode 155. The first upper protection layer 140b is not in contact with the barrier layer 136 and the gate semiconductor layer 152. The first lower protection layer 140a may be positioned between the barrier layer 136 and the first upper protection layer 140b.

The sides of the first lower protection layer 140a and the first upper protection layer 140b may be in contact with the source electrode 173. Additionally, the sides of the first lower protection layer 140a and the first upper protection layer 140b may be in contact with the drain electrode 175. The first lower protection layer 140a and the first upper protection layer 140b may include or be an insulating material or an insulator. In an embodiment, the first lower protection layer 140a and the first upper protection layer 140b include different materials. If the first lower protection layer 140a and the first upper protection layer 140b include the same material, the boundary between the first lower protection layer 140a and the first upper protection layer 140b may not be recognized.

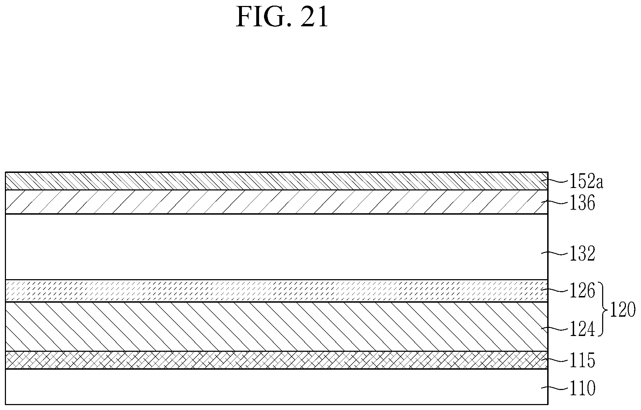

Next, a method of manufacturing a semiconductor device according to an embodiment is described with reference to FIG. 21 to FIG. 27.

FIG. 21 to FIG. 27 are process cross-sectional views shown according to a process order of manufacturing a semiconductor device according to an embodiment.

First, as shown in FIG. 21, a seed layer 115, a buffer layer 120, a channel layer 132, a barrier layer 136, and a gate semiconductor material layer 152a may be sequentially formed on a substrate 110.

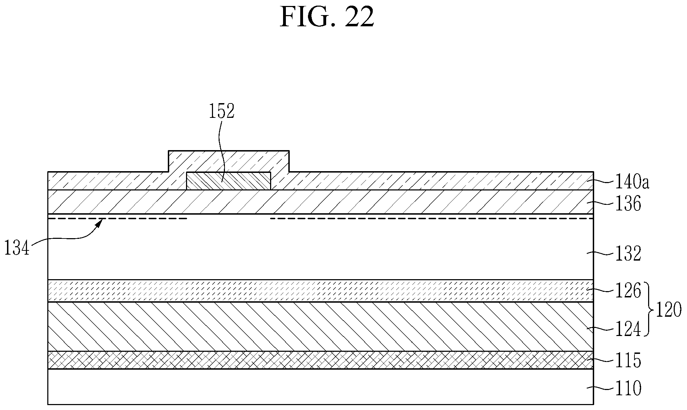

As shown in FIG. 22, the gate semiconductor material layer 152a may be patterned to form a gate semiconductor layer 152. The gate semiconductor layer 152 may have a predetermined width. As the gate semiconductor material layer 152a is patterned, at least a portion of the barrier layer 136 positioned below the gate semiconductor material layer 152a may be exposed.

Next, an insulating material may be deposited on the barrier layer 136 and the gate semiconductor layer 152 to form a first lower protection layer 140a. The first lower protection layer 140a may cover the upper surface of the barrier layer 136 and the upper and side surfaces of the gate semiconductor layer 152.

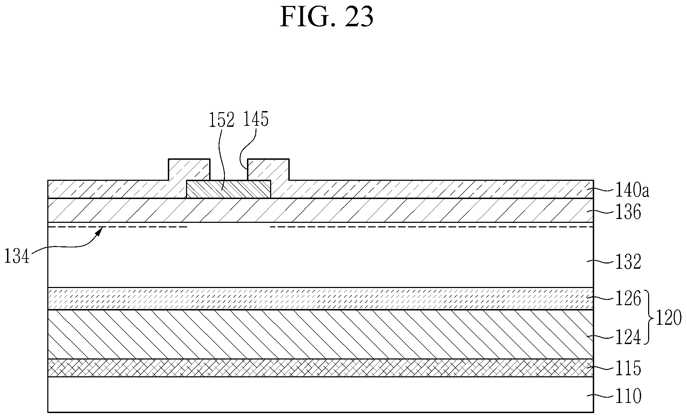

As shown in FIG. 23, the first lower protection layer 140a may be patterned to form an opening 145. The opening 145 of the first lower protection layer 140a may overlap the gate semiconductor layer 152. At least a portion of the gate semiconductor layer 152 may be exposed to the outside by the opening 145. A part of the upper surface of the gate semiconductor layer 152 may be exposed to the outside. For example, a portion of an upper surface of the gate semiconductor layer 152 may be exposed by the opening 145. In an embodiment, the width of the opening 145 is narrower than the width of the gate semiconductor layer 152. Therefore, the entire upper surface of the gate semiconductor layer 152 is not exposed to the outside, and only a portion of the upper surface of the gate semiconductor layer 152 may be exposed to the outside.

The width of the opening 145 is shown as constant, but is not limited thereto. For example, the width of the opening 145 formed in the lower part of the first lower protection layer 140a may be smaller than the width of the opening 145 formed in the upper part. The width of the opening 145 may gradually increase as it moves away from gate semiconductor layer 152.

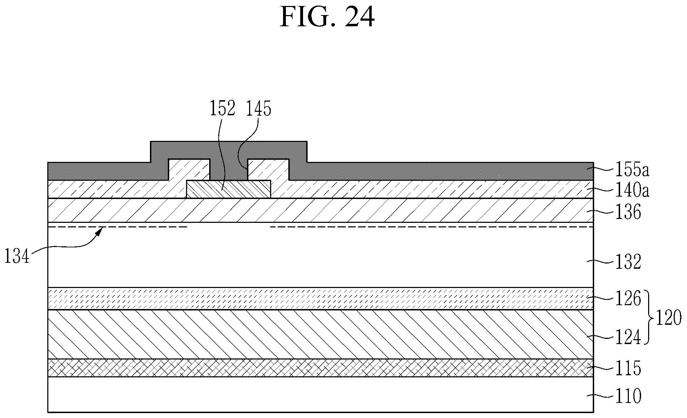

As shown in FIG. 24, a gate electrode material layer 155a can be formed by depositing a conductive material or a conductor on the first lower protection layer 140a. The gate electrode material layer 155a may fill the opening 145 of the first lower protection layer 140a. In an embodiment, at least a portion of the gate electrode material layer 155a that overlaps with the opening 145 is positioned at a lower level than the portion of the gate electrode material layer 155a positioned around the opening 145.

In the present embodiment, the atomic percentage of the materials constituting the gate electrode material layer 155a may be constant. The gate electrode material layer 155a may be formed by supplying a constant flow rate of gas. Accordingly, the gate electrode material layer 155a may have a constant atomic percent along the thickness direction. For example, the gate electrode material layer 155a may include TiN, and the atomic percentage of Ti to the atomic percentage of N in the upper part of the gate electrode material layer 155a may be substantially the same as the atomic percentage of Ti to the atomic percentage of N in the lower part of the gate electrode material layer 155a. However, it is not limited to this, and like the previous embodiment, the atomic percentage of the materials constituting the gate electrode material layer 155a may be different depending on the position.

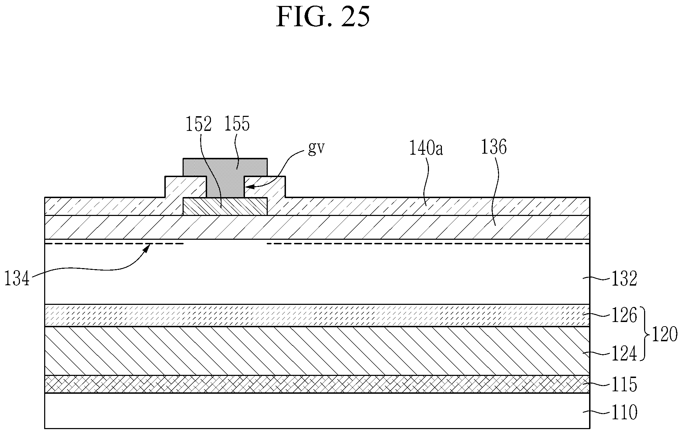

As shown in FIG. 25, a gate electrode 155 may be formed by patterning the gate electrode material layer 155a (e.g., see FIG. 13).

The width of the gate electrode 155 may vary depending on a position. In an embodiment, the width of the portion of the gate electrode 155 positioned within the opening 145 of the first lower protection layer 140a is smaller than the width of the portion of the gate electrode 155 positioned above the first lower protection layer 140a. In an embodiment, the width of the lower part of the gate electrode 155 is smaller than the width of the upper part of the gate electrode 155. The width of the upper part of the gate electrode 155 may be the same as or similar to the width of the gate semiconductor layer 152. The width of the upper part of the gate electrode 155 may be the same or substantially the same as the width of the gate semiconductor layer 152. However, it is not limited to this, and the width of the upper part of the gate electrode 155 may be smaller or larger than the width of the gate semiconductor layer 152. There may be a portion where the gate electrode 155 and the gate semiconductor layer 152 are separated. In the area where the gate electrode 155 and the gate semiconductor layer 152 are separated, the first lower protection layer 140a may be positioned between the gate electrode 155 and the gate semiconductor layer 152. The part where the gate electrode 155 and the gate semiconductor layer 152 are separated may be the groove gv of the gate electrode 155, and the groove gv may be filled by the first lower protection layer 140a.

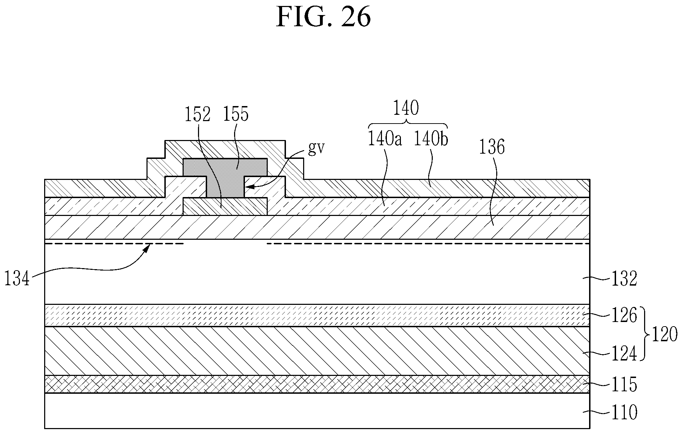

As shown in FIG. 26, a first upper protection layer 140b may be formed by depositing an insulating material on the gate electrode 155 and the first lower protection layer 140a. The first upper protection layer 140b may cover the upper surface and a part of the side surface of the gate electrode 155 and the first lower protection layer 140a. The first lower protection layer 140a and the first upper protection layer 140b may constitute the first protection layer 140. In an embodiment, the first lower protection layer 140a and the first upper protection layer 140b include the same material. In an embodiment, the first lower protection layer 140a and the first upper protection layer 140b include different materials.

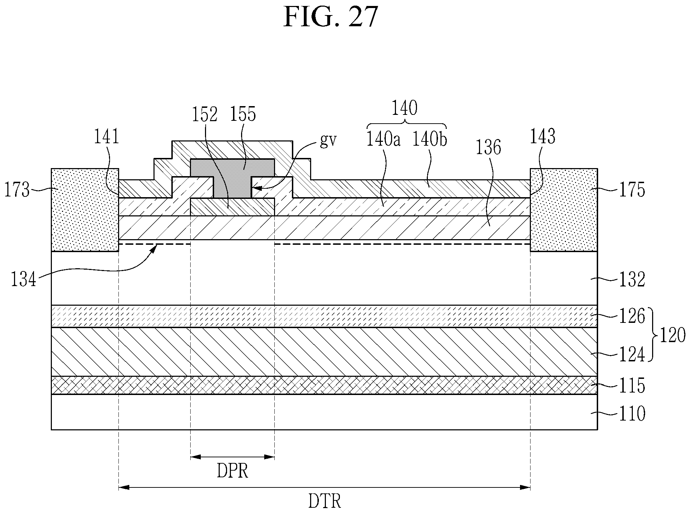

As shown in FIG. 27, a first trench 141 and a second trench 143 may be formed by patterning the first protection layer 140. At this time, not only the first protection layer 140, but also the barrier layer 136 and the channel layer 132 may be patterned together.

A conductive material or a conductor may be deposited on the first protection layer 140 and patterned to form a source electrode 173 and a drain electrode 175. The source electrode 173 may be formed within the first trench 141 and electrically connected to one side of the channel layer 132. The drain electrode 175 may be formed within the second trench 143 and electrically connected to the other side of the channel layer 132.

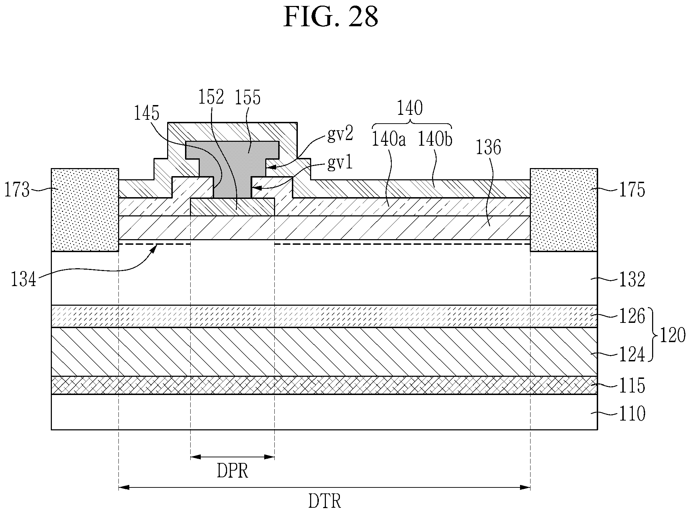

Next, a semiconductor device according to an embodiment is described with reference to FIG. 28.

FIG. 28 is a cross-sectional view showing a semiconductor device according to an embodiment.

Many parts of the embodiment shown in FIG. 28 are the same as the embodiment shown in FIG. 20 so that any redundant description thereof will be omitted and the differences will be mainly explained. Additionally, the same reference numerals are used for the same components as the previous embodiment. The embodiment shown in FIG. 28 is slightly different from the previous embodiment in that the gate electrode includes a first groove and a second groove.

As shown in FIG. 28, a first lower protection layer 140a may be positioned on a barrier layer 136 and a gate semiconductor layer 152, and a gate electrode 155 may be positioned between the first lower protection layer 140a and the first upper protection layer 140b. The gate electrode 155 may be connected to the gate semiconductor layer 152 through an opening 145 formed in the first lower protection layer 140a.

The gate electrode 155 includes a first groove gv1 and a second groove gv2. The first groove gv1 may be positioned below the second groove gv2. The first groove gv1 may be filled by the first lower protection layer 140a. The gate semiconductor layer 152 and the gate electrode 155 may be separated by the first groove gv1, and the first lower protection layer 140a may be positioned between the gate semiconductor layer 152 and the gate electrode 155. The second groove gv2 may be filled by the first upper protection layer 140b. The gate semiconductor layer 152 and the gate electrode 155 may be separated by the second groove gv2, and the first upper protection layer 140b may be positioned between the gate semiconductor layer 152 and the gate electrode 155. Within the second groove gv2, the first upper protection layer 140b may be positioned between the first lower protection layer 140a and the gate electrode 155.

In an embodiment, the width of the portion of the gate electrode 155 adjacent to the first groove gv1 is different from the width of the portion of the gate electrode 155 adjacent to the second groove gv2. The width of the portion of the gate electrode 155 adjacent to the first groove gv1 may be smaller than the width of the portion of the gate electrode 155 adjacent to the second groove gv2. The width of the portion of the gate electrode 155 adjacent to the second groove gv2 may be smaller than the width of the portion of the gate electrode 155 in which the groove is not formed. The width of the lower part of gate electrode 155 may be smaller than the width of the upper part of gate electrode 155. The width of the middle part of the gate electrode 155 may be larger than the width of the lower part of the gate electrode 155 and may be smaller than the width of the upper part. However, it is not limited to this, and the relationship of the width of each part of the gate electrode 155 may be changed in various ways. For example, the width of the middle part of the gate electrode 155 may be smaller than the width of the lower part of the gate electrode 155 and may be smaller than the width of the upper part.

In the present embodiment, the atomic percentage of the materials constituting the gate electrode 155 may vary depending on the position. The second groove gv2 of the gate electrode 155 may be a step caused by a different etching ratio in the etching process depending on the difference in the atomic percentage of the materials constituting the gate electrode 155. The first groove gv of the gate electrode 155 may be a step caused by at least part of the gate electrode 155 being formed to fill the inside of the opening 145 of the first lower protection layer 140a, and the other part being formed above the first lower protection layer 140a.

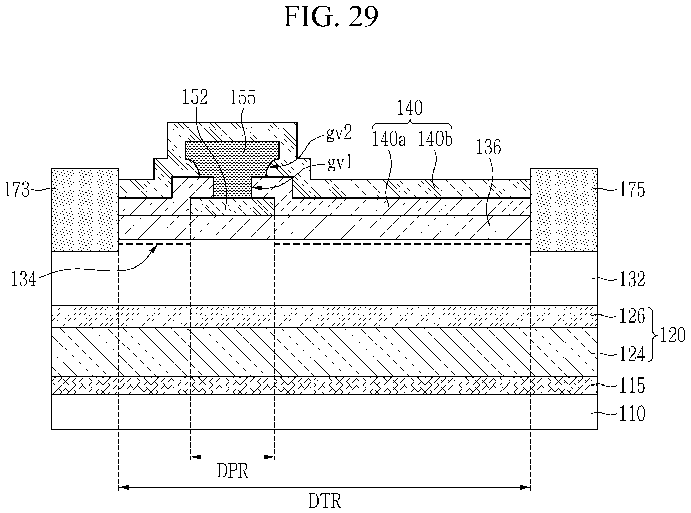

Next, a semiconductor device according to an embodiment is described with reference to FIG. 29.

FIG. 29 is a cross-sectional view showing a semiconductor device according to an embodiment.

Many parts of the embodiment shown in FIG. 29 are the same as the embodiment shown in FIG. 28 so that any redundant description thereof will be omitted and the differences will be mainly explained. Additionally, the same reference numerals are used for the same components as the previous embodiment. In the embodiment shown in FIG. 29, the shape of the second groove is slightly different from the previous embodiment.

As shown in FIG. 29, the gate electrode 155 includes a first groove gv1 and a second groove gv2. In the previous embodiment, the first groove gv1 and the second groove gv2 each have a square shape in a cross-section. In the present embodiment, the first groove gv1 has a square shape in the cross-section, and the second groove gv2 includes a curved surface in the cross-section. The second groove gv2 may have a concave curved surface shape. However, it is not limited to this, and the shapes of the first groove gv1 and the second groove gv2 may be changed in various ways. As an example, the first groove gv1 and the second groove gv2 may both have a curved surface shape.

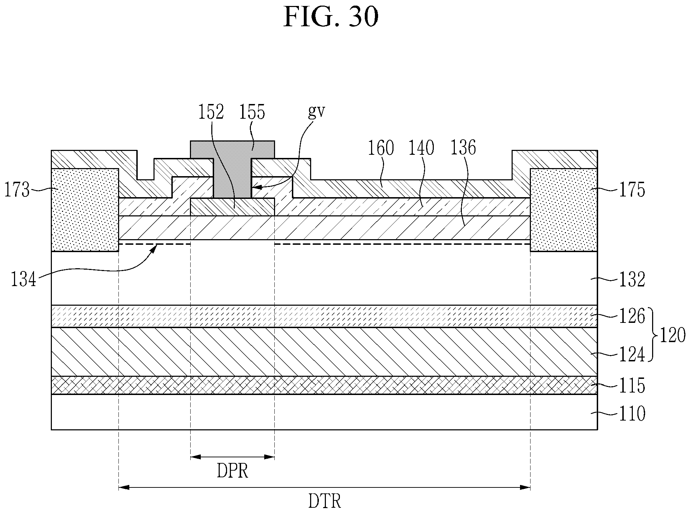

Next, a semiconductor device according to an embodiment is described with reference to FIG. 30.

FIG. 30 is a cross-sectional view showing a semiconductor device according to an embodiment.

Many parts of the embodiment shown in FIG. 30 are the same as the embodiment shown in FIG. 20 so that any redundant description thereof will be omitted and the differences will be mainly explained. Additionally, the same reference numerals are used for the same components as the previous embodiment. The embodiment shown at FIG. 30 is slightly different from the previous embodiment in that it further includes a second protective layer.

As shown in FIG. 30, a first protection layer 140 may be positioned above a barrier layer 136 and a gate semiconductor layer 152. The source electrode 173 and the drain electrode 175 may penetrate the first protection layer 140 and the barrier layer 136 and be connected to the channel layer 132. The semiconductor device according to an embodiment further includes a second protection layer 160 positioned above the first protection layer 140, the source electrode 173, and the drain electrode 175. The upper surface of the first protection layer 140 may be covered by the second protection layer 160. The upper surface and a part of the side surface of the source electrode 173 and the drain electrode 175 may be covered by the second protection layer 160. The gate electrode 155 may be connected to the gate semiconductor layer 152 through the first protection layer 140 and the second protection layer 160.

The gate electrode 155 includes at least one groove gv. The groove gv of the gate electrode 155 may be filled by the first protection layer 140 and the second protection layer 160. In the area where the gate electrode 155 and the gate semiconductor layer 152 are separated, the first protection layer 140 and the second protection layer 160 may be positioned between the gate electrode 155 and the gate semiconductor layer 152.

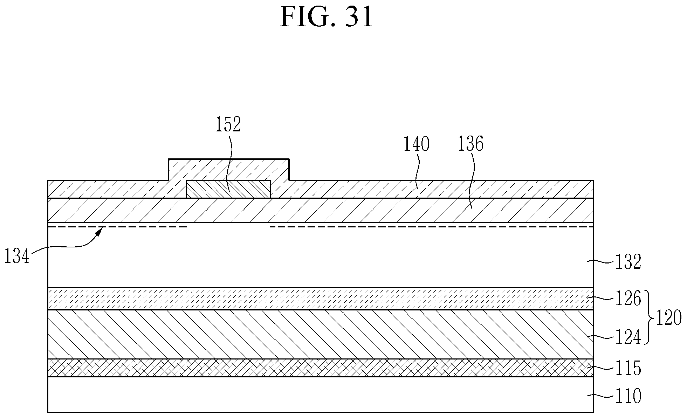

Next, a method of manufacturing a semiconductor device according to an embodiment is described with reference to FIG. 31 to FIG. 34.

FIG. 31 to FIG. 34 are process cross-sectional views showing a semiconductor device according to an embodiment according to a manufacturing process order.

First, as shown in FIG. 31, a seed layer 115, a buffer layer 120, a channel layer 132, a barrier layer 136, and a gate semiconductor material layer may be sequentially formed on a substrate 110, and the gate semiconductor material layer may be patterned to form a gate semiconductor layer 152. Next, a first protection layer 140 may be formed by depositing an insulating material on the barrier layer 136 and the gate semiconductor layer 152.

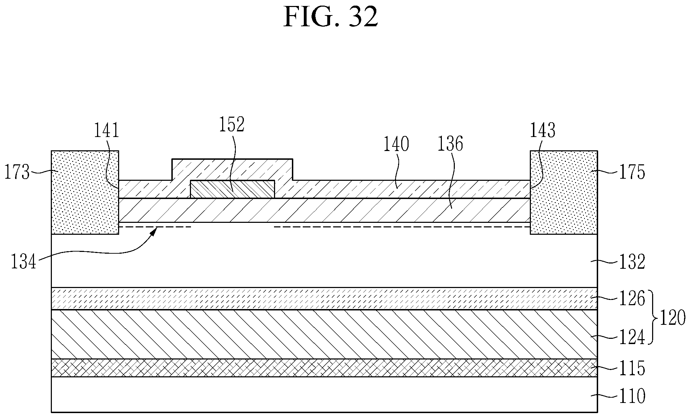

As shown in FIG. 32, the first protection layer 140 may be patterned to form a first trench 141 and a second trench 143. At this time, not only the first protection layer 140 but also the barrier layer 136 and the channel layer 132 may be patterned together.

A conductive material or a conductor may be deposited on the first protection layer 140 and patterned to form the source electrode 173 and drain electrode 175. The source electrode 173 may be formed within the first trench 141 and electrically connected to one side of the channel layer 132. The drain electrode 175 may be formed within the second trench 143 and electrically connected to the other side of the channel layer 132.

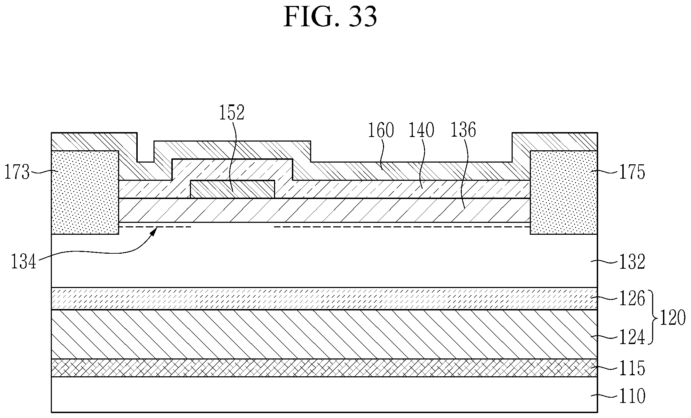

As shown in FIG. 33, a second protection layer 160 may be formed by depositing an insulating material on the first protection layer 140, the source electrode 173, and the drain electrode 175. The second protection layer 160 may cover the upper surface of the first protection layer 140, and may cover the upper surface and a part of the sides of the source electrode 173 and the drain electrode 175.

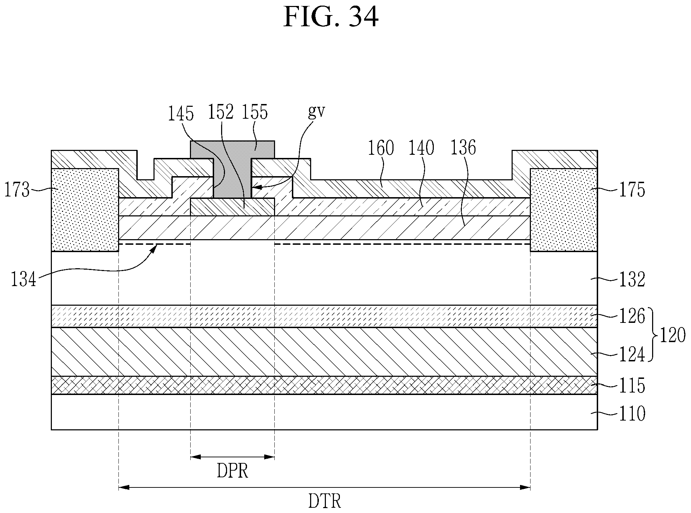

As shown in FIG. 34, a conductive material or a conductor may be deposited on the second protection layer 160 and patterned to form a gate electrode 155. After etching the first protection layer 140 and the second protection layer 160 to form an opening 145, the gate electrode 155 may be formed to fill the opening 145. In the present embodiment, the atomic percentage of the materials constituting the gate electrode 155 may be constant. However, it is not limited to this, and like the previous embodiment, the atomic percentage of the materials constituting the gate electrode 155 may be different depending on the position.

The width of the gate electrode 155 may vary depending on the position. The width of the portion of the gate electrode 155 positioned within the opening 145 of the first protection layer 140 and the second protection layer 160 may be smaller than the width of the portion of the gate electrode 155 positioned above the second protection layer 160. The width of the lower part of the gate electrode 155 may be smaller than the width of the upper part of the gate electrode 155. The width of the upper part of the gate electrode 155 may be the same as or similar to the width of the gate semiconductor layer 152. The width of the upper part of the gate electrode 155 may be the same as or substantially the same as the width of the gate semiconductor layer 152. However, it is not limited to this, and the width of the upper part of the gate electrode 155 may be smaller or larger than the width of the gate semiconductor layer 152. There may be a portion where the gate electrode 155 and the gate semiconductor layer 152 are separated. In the area where the gate electrode 155 and the gate semiconductor layer 152 are separated, the first protection layer 140 and the second protection layer 160 may be positioned between the gate electrode 155 and the gate semiconductor layer 152. The part where the gate electrode 155 and the gate semiconductor layer 152 are separated may be the groove gv of the gate electrode 155, and the groove gv may be filled by the first protection layer 140 and the second protection layer 160.

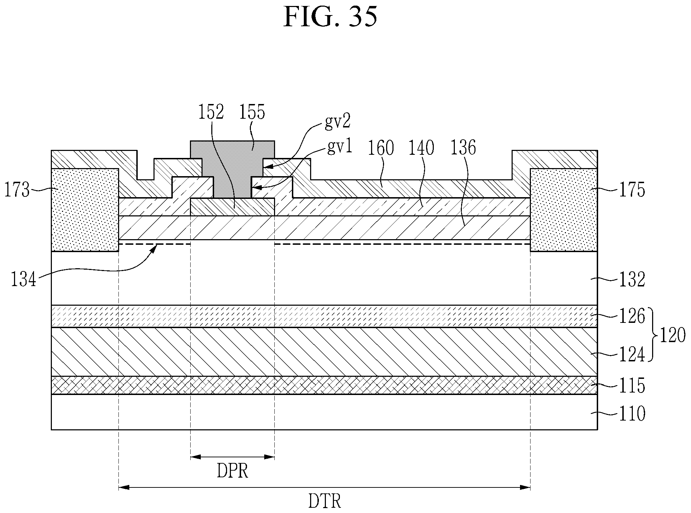

Next, a semiconductor device according to an embodiment is described with reference to FIG. 35.

FIG. 35 is a cross-sectional view showing a semiconductor device according to an embodiment.

Many parts of the embodiment shown in FIG. 35 are the same as the embodiment shown in FIG. 30 so that any redundant description thereof will be omitted and the differences will be mainly explained. Additionally, the same reference numerals are used for the same components as the previous embodiment. The embodiment shown in FIG. 35 is slightly different from the previous embodiment in that the electrode includes a first groove and a second groove.

As shown in FIG. 35, a first protection layer 140 may be positioned on a barrier layer 136 and a gate semiconductor layer. The source electrode 173 and the drain electrode 175 may penetrate the first protection layer 140 and the barrier layer 136 and be connected to the channel layer 132. A second protection layer 160 may be positioned on the first protection layer 140, the source electrode 173, and the drain electrode 175. The gate electrode 155 may be connected to the gate semiconductor layer 152 through the first protection layer 140 and the second protection layer 160.

The gate electrode 155 includes a first groove gv1 and a second groove gv2. The first groove gv1 is positioned below the second groove gv2. The first groove gv1 may be filled by the first protection layer 140. The second groove gv2 may be filled by the second protection layer 160. The width of the portion of the gate electrode 155 adjacent to the first groove gv1 may be smaller than the width of the portion of the gate electrode 155 adjacent to the second groove gv2. The width of the portion of the gate electrode 155 adjacent to the second groove gv2 may be smaller than the width of the portion of the gate electrode 155 in which the groove is not formed. The width of the lower part of gate electrode 155 may be smaller than the width of the upper part of gate electrode 155. The width of the middle part of the gate electrode 155 may be larger than the width of the lower part of the gate electrode 155 and may be smaller than the width of the upper part.

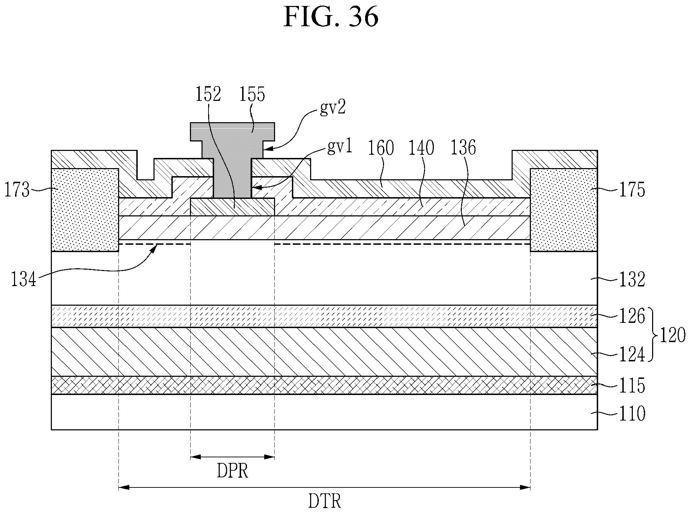

Next, a semiconductor device according to an embodiment is described with reference to FIG. 36.

FIG. 36 is a cross-sectional view showing a semiconductor device according to an embodiment.

Many parts of the embodiment shown in FIG. 36 are the same as the embodiment shown in FIG. 34 so that any redundant description thereof will be omitted and the differences will be mainly explained. Additionally, the same reference numerals are used for the same components as the previous embodiment. The embodiment shown in FIG. 36 is slightly different from the previous embodiment in that the gate electrode include a first groove and a second groove.

As shown in FIG. 36, the gate electrode 155 includes the first groove gv1 and the second groove gv2. The first groove gv1 is positioned below the second groove gv2. The first groove gv1 may be filled by the first protection layer 140 and the second protection layer 160. The width of the portion of the gate electrode 155 adjacent to the first groove gv1 may be smaller than the width of the portion of the gate electrode 155 adjacent to the second groove gv2. The width of the portion of the gate electrode 155 adjacent to the second groove gv2 may be smaller than the width of the portion of the gate electrode 155 in which the groove is not formed. The width of the lower part of gate electrode 155 may be smaller than the width of the upper part of gate electrode 155. The width of the middle part of the gate electrode 155 may be larger than the width of the lower part of the gate electrode 155 and may be smaller than the width of the upper part.

In the present embodiment, the atomic percentage of the materials constituting the gate electrode 155 may vary depending on the position. The second groove gv2 of the gate electrode 155 may be a step caused by a different etching ratio in the etching process depending on the difference in the atomic percentage of the materials constituting the gate electrode 155. The first groove gv of the gate electrode 155 may be a step caused by at least part of gate electrode 155 being formed to fill the inside of the opening of the first protection layer 140 and the second protection layer 160, and the other part being formed on the second protection layer 160.

While this disclosure has been described in connection with what is presently considered to be practical embodiments, it is to be understood that the inventive concept is not limited to the disclosed embodiments, but, on the contrary, is intended to cover various modifications and equivalent arrangements included within the scope of the appended claims.

Embodiments are set out in the following clauses:
Clause 1: A semiconductor device comprising:
   a channel layer;
   a barrier layer positioned above the channel layer and including a material having a different energy band gap than the channel layer;
   a source electrode and a drain electrode positioned on the channel layer;
   a gate electrode positioned above the barrier layer between the source and drain electrodes; and
   a gate semiconductor layer positioned between the barrier layer and the gate electrode,
   wherein a width of the gate electrode is smaller than a width of the gate semiconductor layer at a junction surface of the gate electrode and the gate semiconductor layer.
Clause 2: The semiconductor device of clause 1, wherein a width of a lower part of the gate electrode is smaller than a width of an upper part of the gate electrode.
Clause 3: The semiconductor device of clause 2, wherein the width of the gate electrode gradually increases from the lower part toward the upper part.
Clause 4: The semiconductor device of clause 2, wherein the width of the gate electrode gradually increases and then becomes constant from the lower part toward the upper part.
Clause 5: The semiconductor device of any preceding clause, wherein:
   the gate electrode includes Titanium Nitride (TiN), and
   the composition ratio of Ti to N in the upper part of the gate electrode is lower than the composition ratio of Ti to N in the lower part of the gate electrode.
Clause 6: The semiconductor device of clause 5, wherein the composition ratio of Ti to N in the gate electrode decreases or remains constant as it moves away from the gate semiconductor layer.
Clause 7: The semiconductor device of clause 6, wherein:
   the composition ratio of Ti to N in the lower part of the gate electrode is 40 atomic percent (at%) or more and 60 at% or less, and
   the composition ratio of Ti to N in the upper part of the gate electrode is 20at% or more and 50at% or less.
Clause 8: The semiconductor device of clause 5, wherein the composition ratio of N to Ti in the gate electrode increases or remains constant as it moves away from the gate semiconductor layer.
Clause 9: The semiconductor device of clause 8, wherein:
   the composition ratio of N to Ti in the lower part of the gate electrode is 40 at% or more and 60 at% or less, and
   the composition ratio of N to Ti in the upper part of the gate electrode is 50 at% or more and 80 at% or less.
Clause 10: The semiconductor device of any preceding clause, wherein:
   the gate electrode includes a groove recessed from a bottom surface and a side surface, and
   at least part of the gate electrode is separated from the gate semiconductor layer by the groove.
Clause 11: The semiconductor device of clause 10, wherein a depth of the groove of the gate electrode is 5 nanometer (nm) or more and 300nm or less.
Clause 12: The semiconductor device of clause 10 or 11, wherein a thickness of the gate electrode is 200 Angstroms (Å) or more and 3000Å or less.
Clause 13: The semiconductor device of any of clauses 10 to 12, further comprising a first protective layer positioned above the barrier layer and the gate electrode,
   wherein the first protective layer is positioned between the gate semiconductor layer and the gate electrode within the groove.
Clause 14: The semiconductor device of any of clauses 10 to 13, wherein the groove has at least one of a triangular shape, a square shape, and a step shape, or includes a curved surface in a cross-section.
Clause 15: A semiconductor device comprising:
   a channel layer including Gallium Nitride (GaN);
   a barrier layer positioned above the channel layer and including Aluminum gallium nitride (AlGaN);
   a source electrode and a drain electrode positioned on the channel layer; and
   a gate electrode positioned above the barrier layer between the source electrode and the drain electrode, and including Titanium Nitride (TiN),
   wherein a composition ratio of Ti to N in an upper part of the gate electrode is lower than a composition ratio of Ti to N in a lower part of the gate electrode.
Clause 16: The semiconductor device of clause 15, wherein:
   the composition ratio of Ti to N in the gate electrode decreases or remains constant as it moves away from a gate semiconductor layer,
   the composition ratio of Ti to N in the lower part of the gate electrode is 40 atomic percentage (at%) or more and 60 at% or less, and
   the composition ratio of Ti to N in the upper part of the gate electrode is 20at% or more and 50at% or less.
Clause 17: The semiconductor device of clause 15, wherein:
   the composition ratio of N to Ti in the gate electrode increases or remains constant as it moves away from a gate semiconductor layer,
   the composition ratio of N to Ti in the lower part of the gate electrode is 40 atomic percentage (at%) or more and 60 at% or less, and
   the composition ratio of N to N in the upper part of the gate electrode is 50 at% or more and 80 at% or less.
Clause 18: The semiconductor device of any of clauses 15 to 17, wherein:
   a width of a lower part of the gate electrode is smaller than a width of an upper part of the gate electrode, and
   the width of the lower part of the gate electrode is smaller than the width of a gate semiconductor layer.
Clause 19: A semiconductor device comprising:
   a channel layer;
   a barrier layer positioned above the channel layer and including a material having a different energy band gap than the channel layer;
   a source electrode and a drain electrode positioned on the channel layer;
   a gate electrode positioned above the barrier layer between the source electrode and the drain electrode; and
   a gate semiconductor layer positioned between the barrier layer and the gate electrode,
   wherein a width of a lower part of the gate electrode is smaller than a width of an upper part of the gate electrode.
Clause 20: The semiconductor device of clause 19, wherein:
   the gate electrode includes Titanium Nitride (TiN), and
   a composition ratio of Ti to N in the upper part of the gate electrode is lower than a composition ratio of Ti to N in the lower part of the gate electrode.

## Claims

1. A semiconductor device comprising:
a channel layer;
a barrier layer positioned above the channel layer and including a material having a different energy band gap than the channel layer;
a source electrode and a drain electrode positioned on the channel layer;
a gate electrode positioned above the barrier layer between the source and drain electrodes; and
a gate semiconductor layer positioned between the barrier layer and the gate electrode,
wherein a width of the gate electrode is smaller than a width of the gate semiconductor layer at a junction surface of the gate electrode and the gate semiconductor layer.

2. The semiconductor device of claim 1, wherein a width of a lower part of the gate electrode is smaller than a width of an upper part of the gate electrode.

3. The semiconductor device of claim 2, wherein the width of the gate electrode gradually increases from the lower part toward the upper part.

4. The semiconductor device of claim 2, wherein the width of the gate electrode gradually increases and then becomes constant from the lower part toward the upper part.

5. The semiconductor device of any preceding claim, wherein:
the gate electrode includes Titanium Nitride (TiN), and
the atomic percentage of Ti to the atomic percentage of N in the upper part of the gate electrode is lower than the atomic percentage of Ti to the atomic percentage of N in the lower part of the gate electrode.

6. The semiconductor device of claim 5, wherein the atomic percentage of Ti in the gate electrode decreases or remains constant based on a total number of atoms in the gate electrode as it moves away from the gate semiconductor layer.

7. The semiconductor device of claim 6, wherein:
the atomic percentage of Ti in the lower part of the gate electrode is 40 atomic percent (at%) or more and 60 at% or less based on a total number of atoms in the gate electrode, and
the atomic percentage of Ti in the upper part of the gate electrode is 20at% or more and 50at% or less based on a total number of atoms in the gate electrode.

8. The semiconductor device of claim 5, wherein the atomic percentage of N in the gate electrode increases or remains constant based on a total number of atoms in the gate electrode as it moves away from the gate semiconductor layer.

9. The semiconductor device of claim 8, wherein:
the atomic percentage of N in the lower part of the gate electrode is 40 at% or more and 60 at% or less based on a total number of atoms in the gate electrode, and
the atomic percentage of N in the upper part of the gate electrode is 50 at% or more and 80 at% or less based on a total number of atoms in the gate electrode.

10. The semiconductor device of any preceding claim, wherein:
the gate electrode includes a groove recessed from a bottom surface and a side surface, and
at least part of the gate electrode is separated from the gate semiconductor layer by the groove.

11. The semiconductor device of claim 10, wherein a depth of the groove of the gate electrode is 5 nanometer (nm) or more and 300nm or less.

12. The semiconductor device of claim 10 or 11, wherein a thickness of the gate electrode is 200 Angstroms (Å) or more and 3000Å or less.

13. The semiconductor device of any of claims 10 to 12, further comprising a first protective layer positioned above the barrier layer and the gate electrode,
wherein the first protective layer is positioned between the gate semiconductor layer and the gate electrode within the groove.

14. The semiconductor device of any of claims 10 to 13, wherein the groove has at least one of a triangular shape, a square shape, and a step shape in a cross-section.

15. The semiconductor device of any of claims 10 to 13, wherein the groove includes a curved surface in a cross-section.
